# EUROPEAN PATENT SPECIFICATION

(11) **EP 4 418 039 B1**
(45) Date of publication and mention of the grant of the patent: **28.01.2026**
(21) Application number: 23172536.7
(22) Date of filing: 10.05.2023
(51) Int. Cl.: G02F 1/13357, H10H 20/856

(54) **LIGHT SOURCE MODULE**
LICHTQUELLENMODUL
MODULE DE SOURCE DE LUMIÈRE

(30) Priority: 15.02.2023 TW 112105340
(43) Date of publication of application: 21.08.2024
(73) Proprietor: Eosopto Technology Co., Ltd, Taichung City 407 (TW)
(72) Inventor: YANG, Wen-Hsun, 302058 Zhubei City, Hsinchu County (TW)
(74) Representative: Becker, Eberhard

(56) References cited:
- EP-A1- 3 968 390
- KR-A- 20110 127 387
- US-A1- 2010 265 694
- US-A1- 2021 333 459

## Description

### BACKGROUND

### Technical Field

The disclosure relates to an optical module, and in particular, relates to a light source module.

### Description of Related Art

With the increasing application of non-self-luminous displays such as liquid crystal displays, the design of the backlight modules also needs to be adjusted for different applications. In order to meet the needs of displaying a high dynamic range (HDR) and high contrast for panel products, the backlight modules are required to exhibit local dimming. Therefore, treating the direct-type backlight modules as the main light source structure has gradually become the mainstream of the market. Since this type of backlight modules are expected to achieve a thinner thickness (for example, the optical distance is less than 10 mm), the light emitting device is usually covered with an encapsulation layer having a reflective member or a reflective structure, so as to achieve a relatively uniform light-emitting effect on the light emitting surface of a backlight module.

However, due to the arrangement of the reflective member or the reflective structure, on the light emitting surface of a backlight module of this type, reflective dark spots are likely to be generated in the zone where the light emitting device overlaps, and the uniformity of the overall light emission is thus affected. Therefore, how to improve the light uniformity of the ultra-thin direct-type backlight modules is one of the research and development priorities of related manufacturers.

US 2010/265694 A1 relates to a light emitting device including a reflective layer, light emitting components disposed on the reflective layer, and a resin layer formed on the light emitting components and the reflective layer. KR 2011-0127387 A relates to a backlight unit and a display device to improve a display quality. US 2021/333459 A1 relates to a light guide plate, a backlight module and a display device. EP 3968390 A1 relates to a light source module including a substrate, a light emitting device, a package structure and an optical pattern.

### SUMMARY

The invention is set out in the appended set of claims. The following disclosure serves a better understanding of the present invention. The disclosure provides a light source module exhibiting favorable light output uniformity in a zone overlapping with a light emitting device, and the light pattern of the outputted light is able to be flexibly adjusted.

The disclosure provides a light source module including a substrate, a light emitting device, an encapsulation structure, and an optical pattern. The light emitting device is disposed on a surface of the substrate. The encapsulation structure is disposed on the surface of the substrate and covers the light emitting device. The optical pattern is covered by the encapsulation structure and overlaps the light emitting device. The optical pattern has characteristics of partial penetration and partial reflection and is provided with a first active zone and a second active zone. The first active zone and the second active zone are arranged in a direction parallel to the surface of the substrate. The first active zone and the second active zone of the optical pattern respectively has a first transmittance and a second transmittance, and the first transmittance is different from the second transmittance.

In an embodiment of the disclosure, a first height is provided between a surface of the optical pattern facing the light emitting device and the surface of the substrate in the light source module. The encapsulation structure has a second height in a normal direction of the surface of the substrate, and a ratio of the first height to the second height is less than 0.5.

In an embodiment of the disclosure, the optical pattern of the light source module has a first surface and a second surface facing away from each other. The first surface faces the light emitting device and is parallel to the second surface. The optical pattern is provided with a plurality of reflective particles in the first active zone and the second active zone. A doping concentration of the reflective particles in the first active zone is different from a doping concentration in the reflective particles in the second active zone.

In an embodiment of the disclosure, the holes of the light source module include a plurality of first holes and a plurality of second holes. A first hole diameter of each of the first holes is different from a second hole diameter of each of the second holes.

According to the claimed invention, the optical pattern of the light source module is provided with a plurality of holes. A distribution density of the holes in the first active zone is the same as a distribution density of the holes in the second active zone. The holes include a plurality of first holes and a plurality of second holes. Each of the first holes has a first hole depth, each of the second holes has a second hole depth, and the first hole depth is different from the second hole depth.

In an embodiment of the disclosure, the optical pattern of the light source module has a first surface and a second surface facing away from each other and is provided with a plurality of holes. The holes extend between the first surface and the second surface, and an extending direction of each of the holes is inclined relative to the first surface or the second surface.

In an embodiment of the disclosure, the optical pattern of the light source module has a first surface and a second surface facing away from each other and is provided with a plurality of holes. The first surface has a first opening defining each of the holes. The second surface has a second opening defining each of the holes. An opening area of the first opening is different from an opening area of the second opening.

In an embodiment of the disclosure, the light emitting device of the light source module has a geometric center. The optical pattern is arranged symmetrically about a central axis. The central axis is perpendicular to the surface of the substrate and passes through the geometric center of the light emitting device.

In an embodiment of the disclosure, the encapsulation structure of the light source module is arranged asymmetrically about the central axis.

In an embodiment of the disclosure, the light emitting device of the light source module has a geometric center. The encapsulation structure is arranged symmetrically about a central axis. The optical pattern is arranged asymmetrically about the central axis.

In an embodiment of the disclosure, the light emitting device of the light source module has a geometric center. The encapsulation structure is arranged asymmetrically about a central axis. The central axis is perpendicular to the surface of the substrate and passes through the geometric center of the light emitting device, and the optical pattern is arranged asymmetrically about the central axis.

In an embodiment of the disclosure, the encapsulation structure of the light source module is arranged symmetrically about a central axis. The optical pattern is arranged symmetrically about the central axis. The central axis is perpendicular to the surface of the substrate and does not pass through the light emitting device.

In an embodiment of the disclosure, the substrate of the light source module is a glass substrate, and at least one light beam emitted by the light emitting device is adapted to be transmitted in the glass substrate.

In an embodiment of the disclosure, the light source module further includes a reflective sheet disposed on a side of the glass substrate away from the light emitting device.

In an embodiment of the disclosure, the light source module further includes a reflective layer disposed on the substrate and exposing the light emitting device. The encapsulation structure further includes the reflective layer.

In an embodiment of the disclosure, the encapsulation structure of the light source module has at least one side surface in a direction parallel to the surface of the substrate. An included angle between the at least one side surface and the surface of the substrate is in a range of 10 degrees to 135 degrees.

In an embodiment of the disclosure, a cross-sectional contour of the at least one side surface of the light source module is a straight line or a broken line.

In an embodiment of the disclosure, the optical pattern of the light source module is a plurality of portions separated from each other. The portions are arranged at intervals in an arrangement direction. The arrangement direction is perpendicular to or parallel to the surface of the substrate. A distribution density of the portions in the first active zone is different from a distribution density of the portions in the second active zone.

To sum up, in the light source module provided by an embodiment of the disclosure, the light emitting device and optical pattern that overlap each other are covered by the encapsulation structure. The optical pattern is located on the light outputting side of the light emitting device and has the characteristics of partial penetration and partial reflection. Since the optical pattern is embedded in the encapsulation structure, part of the light beam emitted by the light emitting device is emitted from above the light emitting device through the reflection of the surface of the encapsulation structure and one side surface of the optical pattern away from the light emitting device. Therefore, the problem of the generation of a dark zone caused by the arrangement of the optical pattern above the light emitting device in the light source module may be effectively improved. Further, through the arrangement of different transmittances in different active zones of the optical pattern, the light pattern of the outputted light may be flexibly adjusted.

To make the aforementioned more comprehensible, several embodiments accompanied with drawings are described in detail as follows.

### BRIEF DESCRIPTION OF THE DRAWINGS

The accompanying drawings are included to provide a further understanding of the disclosure, and are incorporated in and constitute a part of this specification. The drawings illustrate exemplary embodiments of the disclosure and, together with the description, serve to explain the principles of the disclosure.
FIG. 1 is a schematic cross-sectional view of a light source module according to the first embodiment of the disclosure.
FIG. 2A is a schematic local enlargement view of the light source module of FIG. 1.
FIG. 2B is a schematic top enlargement view of a light emitting unit of FIG. 1.
FIG. 3A and FIG. 3B are schematic top views of optical patterns according to some other variation examples of the disclosure.
FIG. 4 is a schematic cross-sectional view of a light source module according to the second embodiment of the disclosure.
FIG. 5A is a schematic cross-sectional view of a light source module according to the third embodiment of the disclosure.
FIG. 5B is a schematic top view of the light source module of FIG. 5A.
FIG. 6 is an illuminance distribution map of the light source module of FIG. 5A and FIG. 5B.
FIG. 7 is an illuminance distribution map of a light source module of a comparative example.
FIG. 8 is a schematic three-dimensional view of an optical pattern according to the fourth embodiment of the disclosure.
FIG. 9 to FIG. 13 are schematic three-dimensional views of optical patterns according to some other variation examples of FIG. 8.
FIG. 14 is a schematic cross-sectional view of a light source module according to the fifth embodiment of the disclosure.
FIG. 15 is a schematic local enlargement view of the light source module of FIG. 14.
FIG. 16 is a schematic cross-sectional view of a light source module according to the sixth embodiment of the disclosure.
FIG. 17A is a schematic cross-sectional view of a light source module according to the seventh embodiment of the disclosure.
FIG. 17B to FIG. 17D are schematic cross-sectional views of light source modules according to some other variation examples of FIG. 17A.
FIG. 18 is a schematic cross-sectional view of a light source module according to the eighth embodiment of the disclosure.
FIG. 19 is a schematic local enlargement view of the light source module of FIG. 18.
FIG. 20 is a schematic cross-sectional view of a light source module according to the ninth embodiment of the disclosure.
FIG. 21 is a schematic cross-sectional view of a light source module according to the tenth embodiment of the disclosure.
FIG. 22 is a schematic cross-sectional view of a light source module according to the eleventh embodiment of the disclosure.
FIG. 23 is a schematic cross-sectional view of a light source module according to the twelfth embodiment of the disclosure.
FIG. 24 is a schematic cross-sectional view of the light source module of FIG. 23.
FIG. 25A and FIG. 25B are schematic top views of light emitting units according to some other variation examples of FIG. 2B.
FIG. 26 is a schematic cross-sectional view of a light source module according to the thirteenth embodiment of the disclosure.
FIG. 27A to FIG. 27D are schematic cross-sectional views of light source modules according to some other variation examples of FIG. 26.

### DESCRIPTION OF THE EMBODIMENTS

In the following detailed description of the preferred embodiments, reference is made to the accompanying figures which form a part hereof, and in which are shown by way of illustration specific embodiments in which the invention may be practiced. The language used to describe the directions such as up, down, left, right, front, back or the like in the following embodiment is regarded in an illustrative rather than in a restrictive sense. As such, the directional terminology is used for purposes of illustration and is in no way limiting.

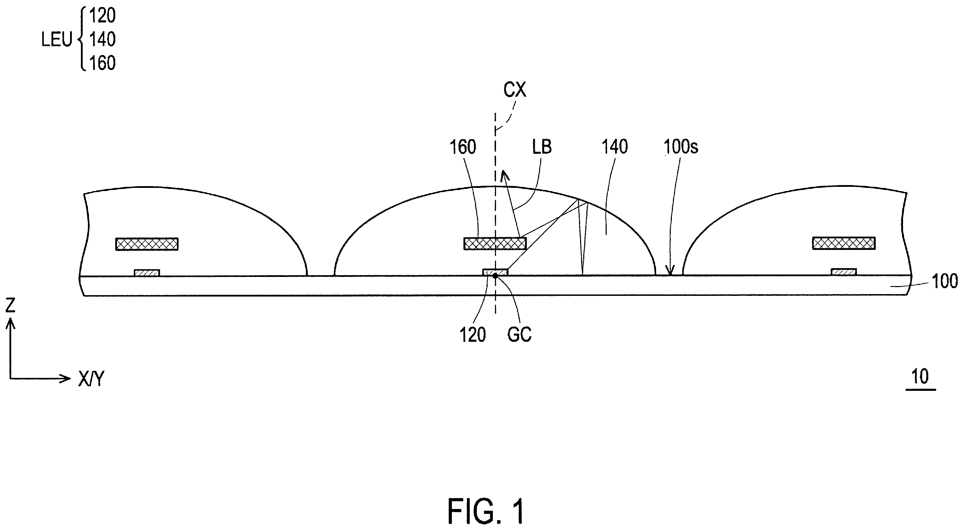

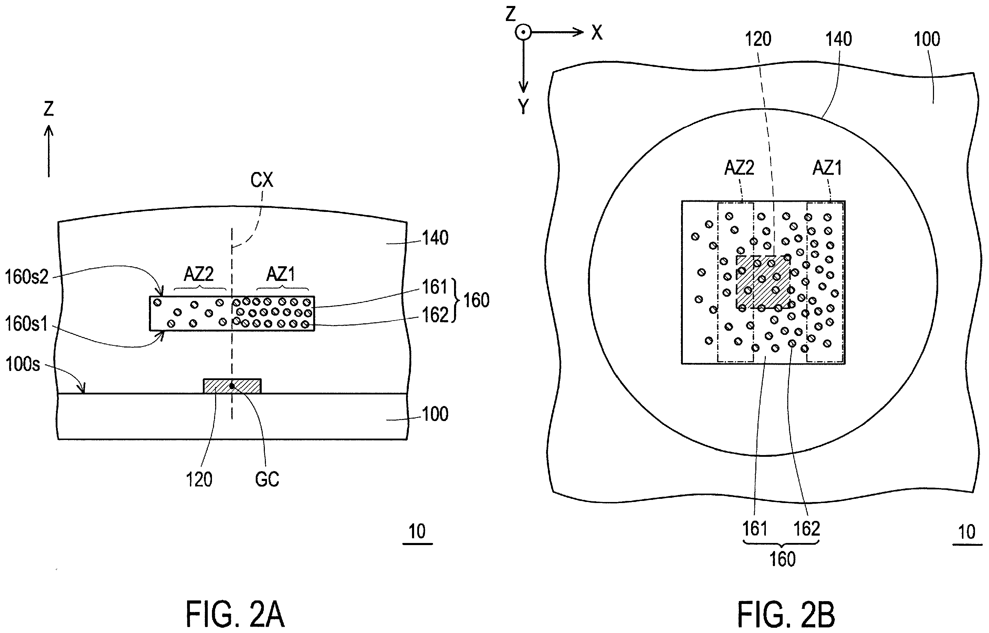

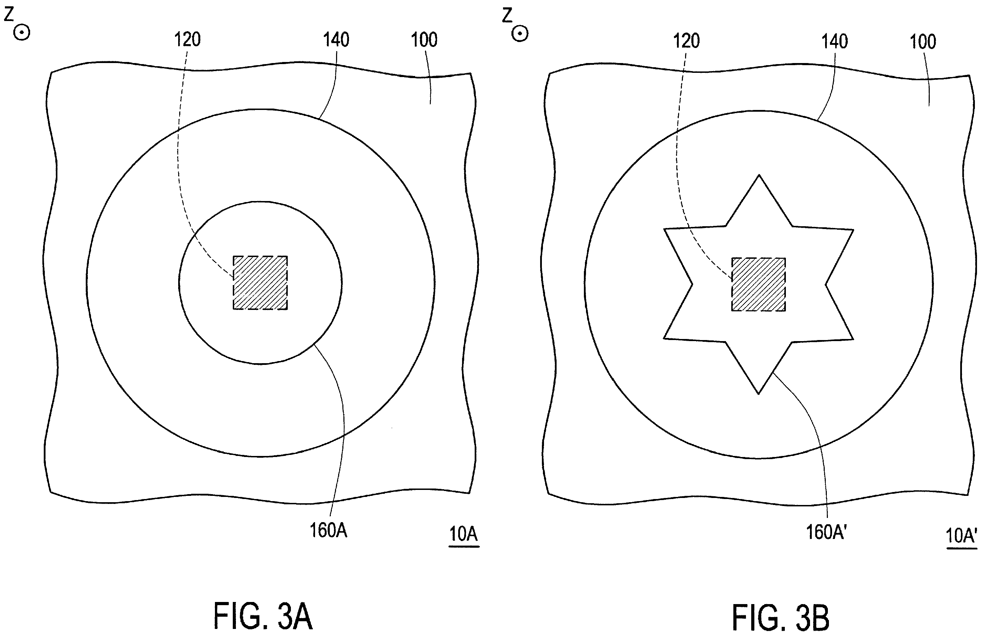

FIG. 1 is a schematic cross-sectional view of a light source module according to the first embodiment of the disclosure. FIG. 2A is a schematic local enlargement view of the light source module of FIG. 1. FIG. 2B is a schematic top enlargement view of a light emitting unit of FIG. 1. FIG. 3A and FIG. 3B are schematic top views of optical patterns according to some other variation examples of the disclosure.

With reference to FIG. 1 to FIG. 2B, a light source module 10 includes a substrate 100 and a plurality of light emitting units LEU. The light emitting units LEU may be arranged in an array on the substrate 100, for example, arranged in a plurality of rows and columns in a direction X and a direction Y, but not limited thereto. The substrate 100 is, for example, a printed circuit board (PCB) or a circuit board made of bismaleimide triazine (BT), but not limited thereto. In this embodiment, in order to meet the needs of light output of a large area, the light emitting units LEU may be arranged at intervals, but not limited thereto. In other embodiments, the light emitting units of the light source module may also be arranged in connection with each other.

Each light emitting unit LEU includes a light emitting device 120 and an encapsulation structure 140. The light emitting device 120 and the encapsulation structure 140 are disposed on a surface 100s of the substrate 100, and the encapsulation structure 140 covers the light emitting device 120. In this embodiment, the light emitting device 120 may be a light emitting diode (LED) including, for example, a submillimeter light emitting diode (mini LED) or a micro light emitting diode (micro LED). The material of the encapsulation structure 140 includes, for example, plastic, a resin material (e.g., acrylic), or other suitable transparent encapsulation materials.

In this embodiment, an orthographic projection contour of the encapsulation structure 140 on the surface 100s of the substrate 100 is, for example, a circle, and a cross-sectional contour of the encapsulation structure 140 parallel to XZ plane or YZ plane is, for example, a semi-ellipse shape or a quasi-semi-ellipse shape, but not limited thereto. On the other hand, the light emitting device 120 may have a geometric center GC, and the encapsulation structure 140 may be symmetrically arranged about a central axis CX. That is, two portions of the encapsulation structure 140 on both sides of the central axis CX are mirror-symmetrical, but not limited thereto. In this embodiment, the central axis CX is perpendicular to the surface 100s of the substrate 100 and passes through the geometric center GC of the light emitting device 120, but not limited thereto.

It should be noted that in this embodiment, the number of light emitting device 120 covered by one encapsulation structure 140 is exemplarily described as one, which does not mean that the disclosure is limited thereto. In other embodiments, the number of the light emitting devices 120 covered by each encapsulation structure 140 may also be two or greater, for example, three light emitting devices that can emit red light, green light, and blue light.

In order to increase the light mixing effect between different light emitting units LEU without increasing the overall thickness of the light source module to improve the overall light output uniformity of the light source module 10, each light emitting unit LEU is also provided with an optical pattern 160. The optical pattern 160 is located on the side of the light emitting device 120 away from the substrate 100 (i.e., the light output side of the light emitting device 120) and is arranged to overlap the light emitting device 120 in a normal direction (e.g., a direction Z) of the surface 100s of the substrate 100. The optical pattern 160 has characteristics of partial reflection and partial transmission, that is, the optical pattern 160 can allow a portion of a light beam emitted by the light emitting device 120 to pass through and can reflect another portion of the light beam emitted by the light emitting device 120.

It is particularly noted that the optical pattern 160 is embedded in the encapsulation structure 140 and is covered by the encapsulation structure 140. That is, the optical pattern 160 is not exposed by the encapsulation structure. Since a portion of the encapsulation structure 140 on the side of the optical pattern 160 away from the light emitting device 120 may be treated as a light guide layer, a portion of the light beam emitted by the light emitting device 120 may be outputted from an upper region of the optical pattern 160 after multiple reflections from multiple interfaces (for example, the light ray LB as shown in FIG. 1). In this way, the decrease in light output brightness caused by the arrangement of the optical pattern 160 above the light emitting device 120 in the light source module may be effectively suppressed (that is, the problem of generation of a dark zone is improved).

On the other hand, the optical pattern 160 may be provided with a plurality of active zones on a light output path of the light emitting device 120, and these active zones are arranged in a direction parallel to the surface 100s of the substrate 100, for example. The optical pattern 160 has a first surface 160s1 facing the light emitting device 120 and a second surface 160s2 facing away from the first surface 160s1. It should be noted that in this embodiment, the first surface 160s1 and the second surface 160s2 of the optical pattern 160 may be parallel to each other, and the active zones of the optical pattern 160 may exhibit different transmittances for the light beam emitted by the light emitting device 120.

In detail, the optical pattern 160 may include a light-transmitting substrate 161 and a plurality of reflective particles 162 dispersedly disposed in the light-transmitting substrate 161. The material of the light-transmitting substrate 161 includes, for example, acrylic, epoxy, hexamethyldisiloxane (HMDSO), or other suitable polymer materials. The material of the reflective particles 162 includes, for example, silicon dioxide (SiO₂), titanium dioxide (TiO₂), a metal material, or a combination of the foregoing, or other materials with appropriate reflectances.

By adjusting a doping concentration of the reflective particles 162 in each active zone, different active zones of the optical pattern 160 may have different transmittances. Further, the light transmittances are adjusted between 5% and 60%, for example, to meet different optical design needs, for example, the light pattern of the outputted light may be flexibly adjusted. For instance, in this embodiment, the doping concentration of the reflective particles 162 in a first active zone AZ1 may be selectively higher than that in a second active zone AZ2 (as shown in FIG. 2A and FIG. 2B). Therefore, in the optical pattern 160, a first transmittance of the first active zone AZ1 may be less than a second transmittance of the second active zone AZ2.

To be more specific, in the optical pattern 160 provided by this embodiment, the doping concentration of the reflective particles 162 may gradually decrease from one side of the optical pattern 160 to the other side (e.g., from the right side to the left side in the figure), but not limited thereto. Therefore, the transmittances of the optical pattern 160 may gradually increase from one side of the first active zone AZ1 to one side of the second active zone AZ2, or reflectances of the optical pattern 160 may gradually decrease gradually from one side of the first active zone AZ1 to one side of the second active zone AZ2.

In this embodiment, the orthographic projection contour of the optical pattern 160 on the substrate 100 is, for example, a square, but not limited thereto. In another embodiment, the orthographic projection contour of an optical pattern 160A of a light source module 10A on the substrate 100 may also be a circle (as shown in FIG. 3A). In still another embodiment, the orthographic projection contour of an optical pattern 160A' of a light source module 10A' on the substrate 100 may also be a polygon (as shown in FIG. 3B).

Some other embodiments are listed below to illustrate the disclosure in detail. Identical reference numerals are used to represent identical components, and descriptions of identical technical contents are omitted. For the omitted parts, description thereof may be found with reference to the foregoing embodiments, which is described in detail below.

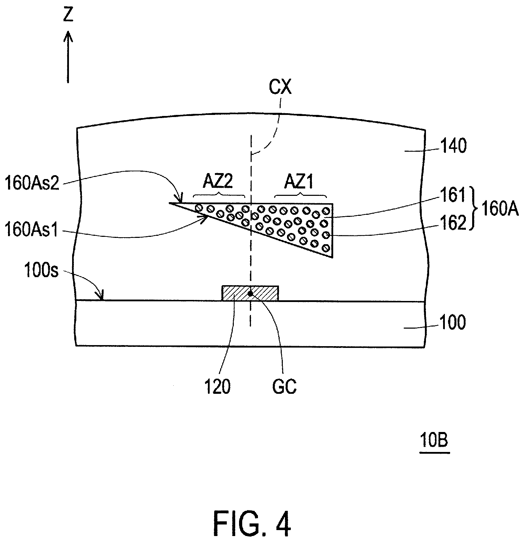

FIG. 4 is a schematic cross-sectional view of a light source module according to the second embodiment of the disclosure. With reference to FIG. 4, the difference between a light source module 10B of this embodiment and the light source module 10 of FIG. 2A is that: the configurations of the optical patterns are different. To be specific, in the light source module 10B of this embodiment, the concentrations of reflective particles 162 doped in different active zones of the optical pattern 160A are substantially the same. For instance, the doping concentration of the reflective particles 162 in the first active zone AZ1 is the same as the doping concentration of the reflective particles 162 in the second active zone AZ2.

It is particularly noted that in this embodiment, a first surface 160As1 of the optical pattern 160A is inclined relative to a second surface 160As2. Further, the optical pattern 160A is arranged asymmetrically about the central axis CX passing through the geometric center GC of the light emitting device 120, but not limited thereto.

In this embodiment, although the doping concentrations of the reflective particles 162 in different active zones of the optical pattern 160A are substantially the same, thicknesses of the optical pattern 160A in different active zones are different. Therefore, the transmittances of the optical pattern 160A in different active zones can still be different. For instance, in the optical pattern 160A, the first transmittance of the first active zone AZ1 may be less than the second transmittance of the second active zone AZ2, or the reflectances of the optical pattern 160A gradually decrease from one side of the first active zone AZ1 to one side of the second active zone AZ2 in FIG. 4.

Through the above arrangement, the phenomenon of the generation of a dark zone caused by the arrangement of the optical pattern 160A above the light emitting device 120 in the light source module 10B may be improved, and the needs of light output of an asymmetrically light pattern are satisfied.

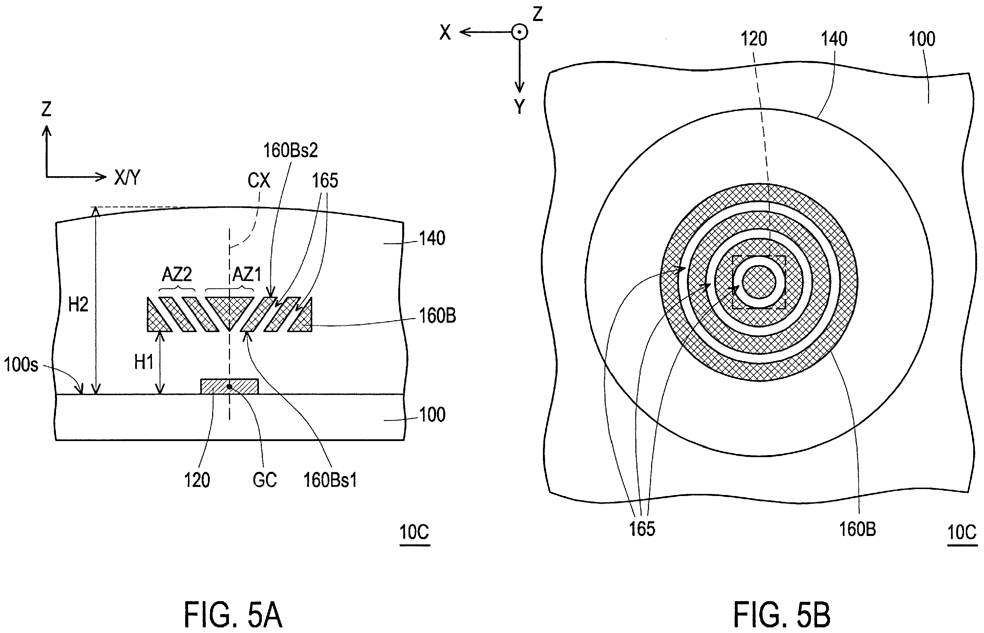

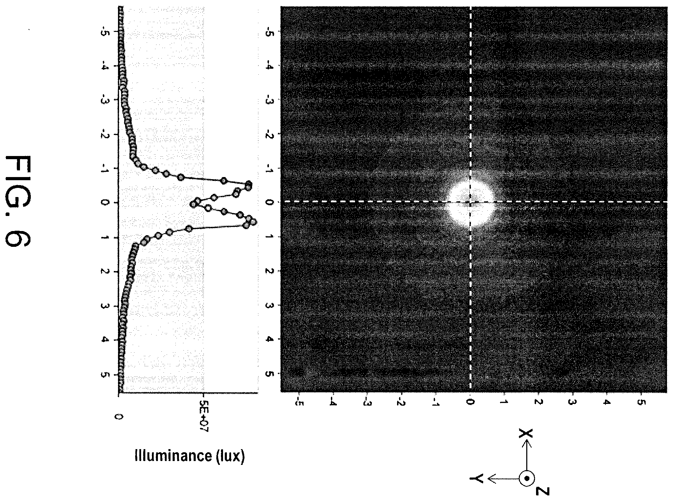

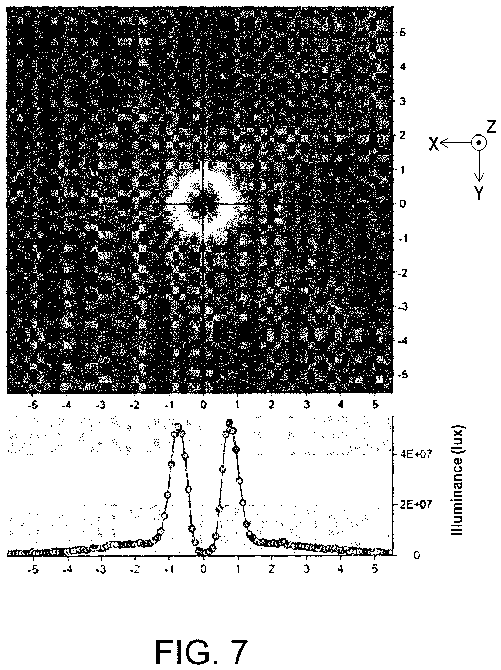

FIG. 5A is a schematic cross-sectional view of a light source module according to the third embodiment of the disclosure. FIG. 5B is a schematic top view of the light source module of FIG. 5A. FIG. 6 is an illuminance distribution map of the light source module of FIG. 5A and FIG. 5B. FIG. 7 is an illuminance distribution map of a light source module of a comparative example.

With reference to FIG. 5A and FIG. 5B, the difference between a light source module 10C of this embodiment and the light source module 10 of FIG. 2A and FIG. 2B is that: the configurations of the optical patterns are different. In this embodiment, an outer contour of an optical pattern 160B of the light source module 10C on a cross section parallel to the XZ plane or the YZ plane is substantially similar to the optical pattern 160 of FIG. 2A. However, different from the optical pattern 160 in FIG. 2B, the outer contour of the orthographic projection of the optical pattern 160B on the substrate 100 in this embodiment is, for example, a circle.

It is particularly noted that in this embodiment, the optical pattern 160B may be provided with a plurality of holes 165, such as a plurality of annular holes surrounding the central axis CX (or the light emitting device 120). Each of these annular holes extends from a first surface 160Bs1 to a second surface 160Bs2 of the optical pattern 160B, and an extending direction thereof substantially passes through the light emitting device 120, but not limited thereto.

Through the arrangement of these holes 165, different active zones of the optical pattern 160B can have different transmittances (or reflectances). For instance, in the optical pattern 160B in this embodiment, the first transmittance of the first active zone AZ1 may be less than the second transmittance of the second active zone AZ2. That is, in the optical pattern 160B, the reflectance of the first active zone AZ1 may be greater than the reflectance of the second active zone AZ2.

In this embodiment, a first height H1 is provided between the first surface 160Bs1 of the optical pattern 160B facing the light emitting device 120 and the surface 100s of the substrate 100. A second height H2 is provided between the encapsulation structure 140 and the surface 100s of the substrate 100. The first height H1 and the second height H2 are, for example, defined in the normal direction (i.e., the direction Z) of the surface 100s of the substrate 100. Further, the second height H2 is, for example, defined by the portion of the encapsulation structure 140 overlapping the optical pattern 160B and the light emitting device 120 in the direction Z.

Preferably, a ratio of the first height H1 to the second height H2 may be less than 0.5. For instance, when the first height H1 of the optical pattern 160B is 0.3 mm, the second height H2 of the encapsulation structure 140 is 0.7 mm. Further, when the reflectance of the optical pattern is 100%, the arrangement of the plurality of holes 165 can effectively prevent the light source module 10C from generating an obvious dark zone above the optical pattern 160B, as shown in FIG. 6.

It should be particularly noted that if the optical pattern is not provided with the plurality of holes 165 but the ratio range of the first height H1 to the second height H2 is still satisfied, the brightness change at the edge of the dark zone above the optical pattern in the formed light source module (i.e., the comparative example) can be moderate (that is, there is a fogging effect at the edge of the dark zone), as shown in FIG. 7.

Comparing FIG. 6 and FIG. 7, it can be seen that the design of the holes 165 on the optical pattern 160B can effectively prevent the light source module 10C from generating an obvious dark spot in the zone above the optical pattern 160B while ensuring the reflection capability of the optical pattern 160B. Further, the light output brightness in the zone may be significantly improved.

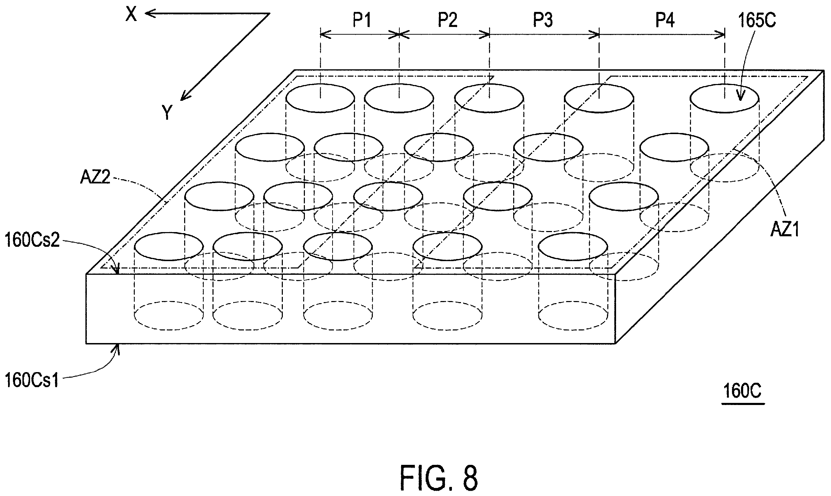

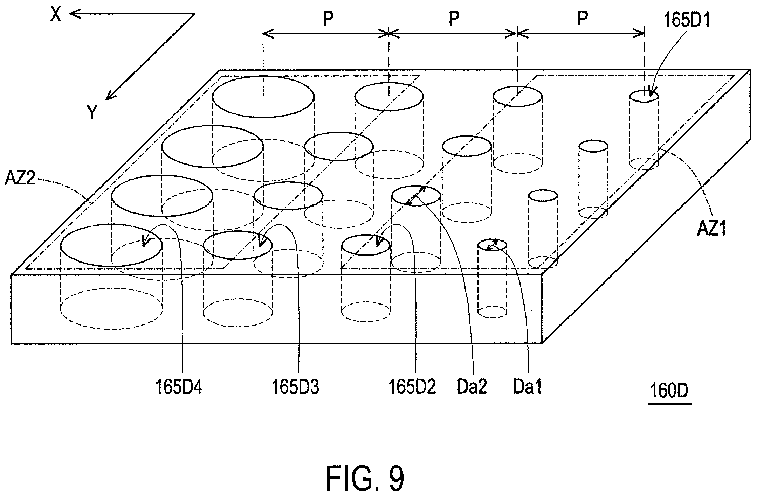

FIG. 8 is a schematic three-dimensional view of an optical pattern according to the fourth embodiment of the disclosure. FIG. 9 to FIG. 13 are schematic three-dimensional views of optical patterns according to some other variation examples of FIG. 8.

With reference to FIG. 8, the difference between an optical pattern 160C of this embodiment and the optical pattern 160B of FIG. 5A is that: the configurations and arrangements of the holes are different. To be specific, each hole 165C of the optical pattern 160C in this embodiment is, for example, cylindrical. That is, opening contours of each hole 165C defined by a first surface 160Cs1 and a second surface 160Cs2 of the optical pattern 160C may be circular, but not limited thereto. In this embodiment, opening areas of the holes 165C on the first surface 160Cs1 and the second surface 160Cs2 are substantially the same.

On the other hand, in this embodiment, the holes 165C may be arranged in a plurality of rows and columns in the direction X and the direction Y. It is particularly noted that the arrangement pitch of the holes 165C in the direction X is not fixed. For instance, the holes 165C are arranged in successively decreasing pitch P4, pitch P3, pitch P2, and pitch P1 from one side of the first active zone AZ1 to the other side of the second active zone AZ2 of the optical pattern 160C.

From another point of view, a distribution density of the holes 165C in the first active zone AZ1 is less than a distribution density of the holes 165C in the second active zone AZ2. Therefore, in the optical pattern 160C, the first transmittance of the first active zone AZ1 is less than the second transmittance of the second active zone AZ2.

Nevertheless, the disclosure is not limited thereto. With reference to FIG. 9, in an optical pattern 160D provided by a variation example, the arrangement pitches of the plurality of holes in the direction X and the direction Y may also be fixed, but the opening sizes of these holes may have various sizes.

For instance, in the optical pattern 160D shown in FIG. 9, the hole 165D1, the hole 165D2, the hole 165D3, and the hole 165D4 may be arranged at intervals in the direction X at a fixed pitch P, and the hole diameters of these holes are different from each other. Arranged according to the hole diameters of the holes, the hole 165D1, the hole 165D2, the hole 165D3, and the hole 165D4 are arranged in a descending order. For instance, a hole diameter Da1 of the hole 165D1 may be smaller than a hole diameter Da2 of the hole 165D2, and the rest may be deduced by analogy. Through the above arrangement, in the optical pattern 160D, the distribution density of the holes in the first active zone AZ1 is less than the distribution density of the holes in the second active zone AZ2. Therefore, in the optical pattern 160D, the first transmittance of the first active zone AZ1 is less than the second transmittance of the second active zone AZ2.

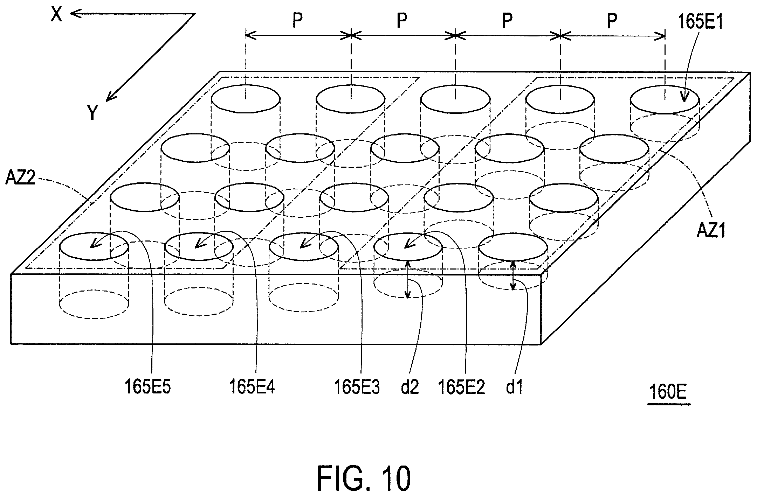

With reference to FIG. 10, in an optical pattern 160E according to the invention, the arrangement of the holes is similar to that of the optical pattern 160D in FIG. 9, for example, a hole 165E1, a hole 165E2, a hole 165E3, a hole 165E4, and a hole 165E5 are arranged at intervals in the direction X with a fixed pitch P in sequence. The difference is that the holes of the optical pattern 160E can have various hole depths.

For instance, the hole depths of the holes in the optical pattern 160E gradually increase from one side of the first active zone AZ1 to one side of the second active zone AZ2, for example: a hole depth d2 of the hole 165E2 is greater than a hole depth d1 of the hole 165E1, and the rest may be deduced by analogy. In this embodiment, the hole 165E1, the hole 165E2, the hole 165E3, and the hole 165E4 may each be a blind hole not penetrating the optical pattern 160E, and the hole 165E5 may be a through hole penetrating the optical pattern 160E, but not limited thereto. Through the above arrangement, in the optical pattern 160E, the distribution density of the holes in the first active zone AZ1 is less than the distribution density of the holes in the second active zone AZ2. Therefore, in the optical pattern 160E, the first transmittance of the first active zone AZ1 is less than the second transmittance of the second active zone AZ2.

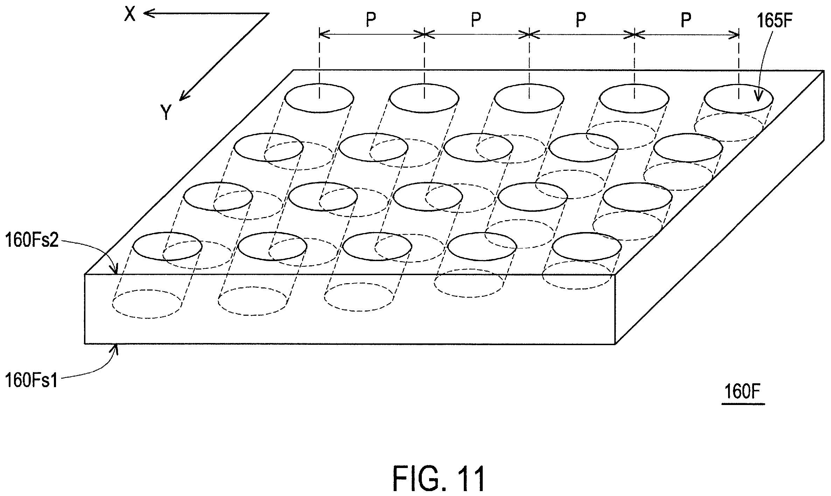

FIG. 11 to FIG. 13 illustrate some other variation examples of the optical pattern 160E in FIG. 10. In these variation examples, the arrangement of the plurality of holes in the optical pattern and the distribution of the hole depths are similar to that in the optical pattern 160E of FIG. 10, and repeated description is thus not provided herein. As shown in FIOG. 11, the extending direction of a plurality of holes 165F of an optical pattern 160F may be inclined relative to a first surface 160Fs1 or a second surface 160Fs2.

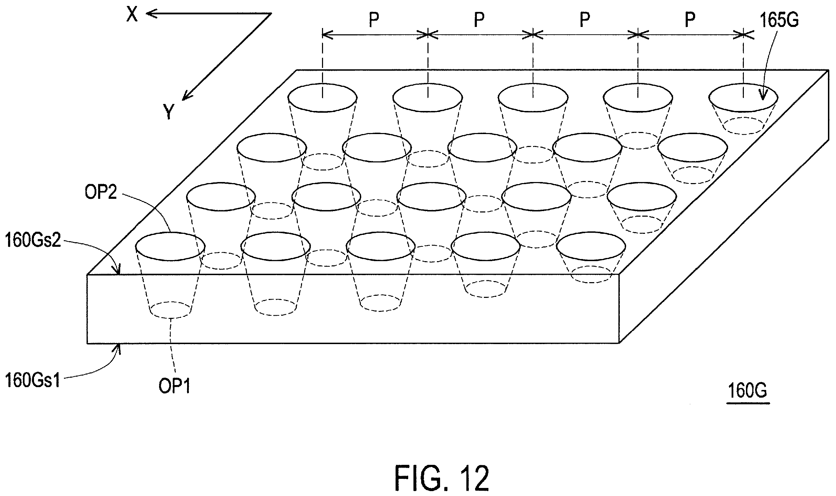

As shown in FIG. 12, a first surface 160Gs1 of an optical pattern 160G has a first opening OP1 defining a hole 165G, and a second surface 160Gs2 thereof has a second opening OP2 defining a hole 165G. Further, an opening area of the first opening OP1 is different from an opening area of the second opening OP2. For instance, the hole diameter of the hole 165G of the optical pattern 160G gradually increases from the first surface 160Gs1 to the second surface 160Gs2, but not limited thereto.

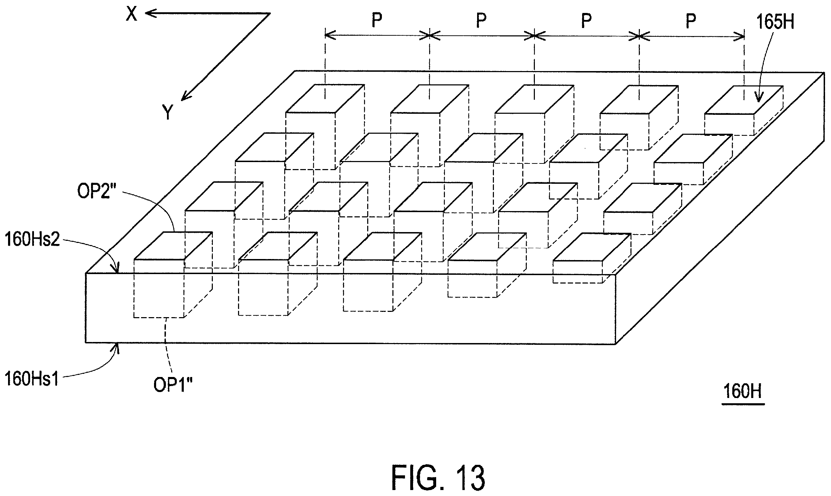

As shown in FIG. 13, a first surface 160Hs1 of an optical pattern 160H has a first opening OP1" defining a hole 165H, and a second surface 160Hs2 thereof has a second opening OP2" defining a hole 165H. The opening contours of the first opening OP1" and the second opening OP2" are, for example, square or rectangular, but not limited thereto. In other embodiments that are not shown, the opening contours of the holes may also be polygonal.

Although the optical pattern 160B in FIG. 5A and FIG. 5B and the optical pattern in FIG. 8 to FIG. 13 are not shown, these optical patterns may be uniformly doped with the plurality of reflective particles 162 as shown in FIG. 4. It should be particularly noted that in another variation example, through the non-uniform distribution of the reflective particles 162 (as shown in FIG. 2A), the flexibility of adjusting the transmittances of different active zones in any optical pattern in FIG. 5A and FIG. 8 to FIG. 13 may be further increased.

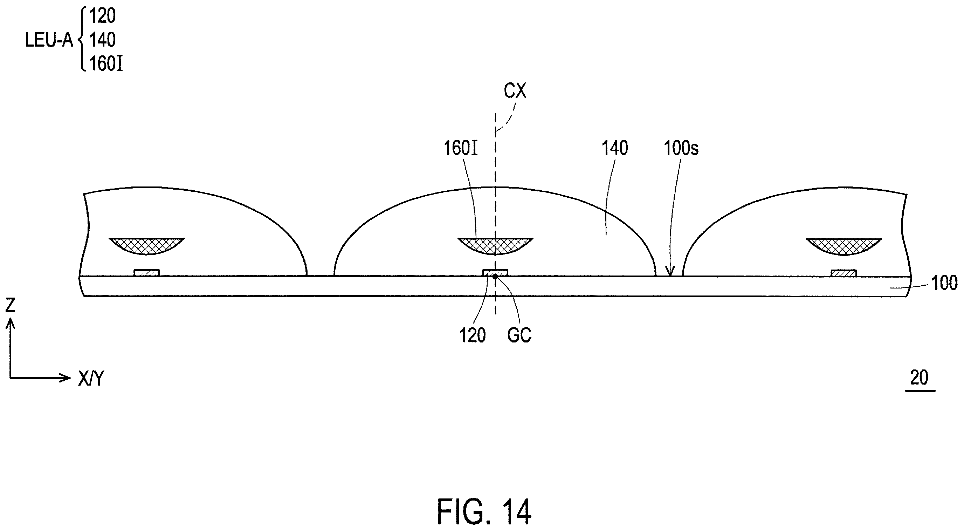

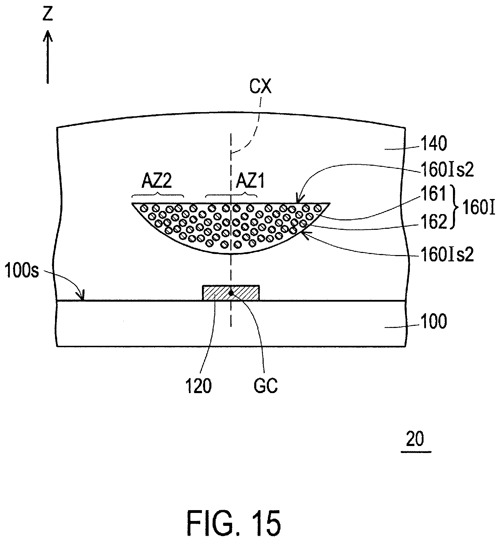

FIG. 14 is a schematic cross-sectional view of a light source module according to the fifth embodiment of the disclosure. FIG. 15 is a schematic local enlargement view of the light source module of FIG. 14. With reference to FIG. 14 and FIG. 15, the difference between a light source module 20 of this embodiment and the light source module 10B of FIG. 4 is that: the configurations of the optical patterns are different. In this embodiment, an optical pattern 1601 of a light emitting unit LEU-A may be arranged symmetrically about the central axis CX passing through the geometric center GC of the light emitting device 120.

More specifically, a cross-sectional contour of the optical pattern 160I parallel to the XZ plane or the YZ plane is, for example, a half-moon shape. The distance between a first surface 160Is1 and a second surface 160Is2 gradually decreases as the distance from the central axis CX increases. That is, the portion of the optical pattern 160I allowing the central axis CX to pass through has the largest thickness. Therefore, when the reflective particles 162 are uniformly dispersed in the light-transmitting substrate 161, in the optical pattern 160I, the transmittance of the first active zone AZ1 is less than the transmittance of the second active zone AZ2, or in the optical pattern 160I, the reflectance of the first active zone AZ1 may be greater than the reflectance of the second active zone AZ2.

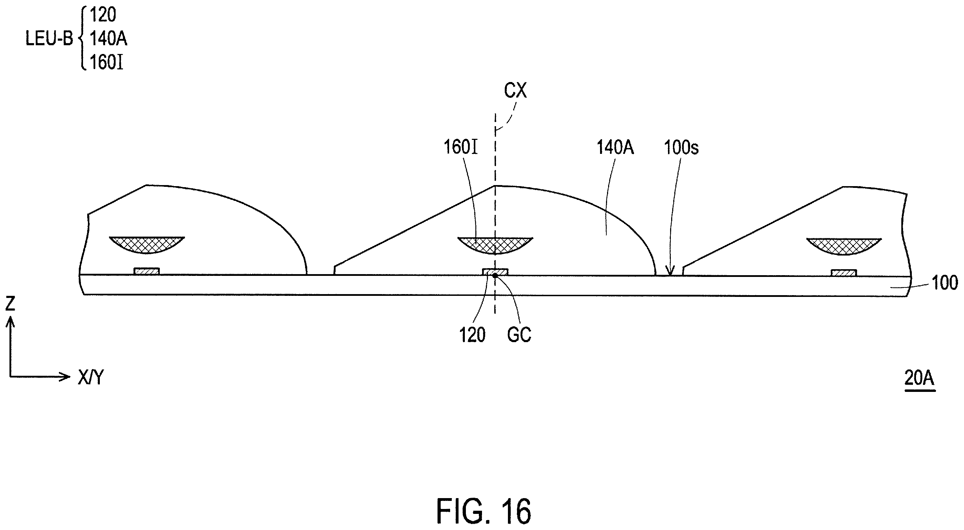

FIG. 16 is a schematic cross-sectional view of a light source module according to the sixth embodiment of the disclosure. With reference to FIG. 16, the difference between a light source module 20A of this embodiment and the light source module 20 of FIG. 14 is that: the configurations of the encapsulation structures are different. To be specific, in this embodiment, an encapsulation structure 140A of a light emitting unit LEU-B is arranged asymmetrically about the central axis CX passing through the geometric center GC of the light emitting device 120.

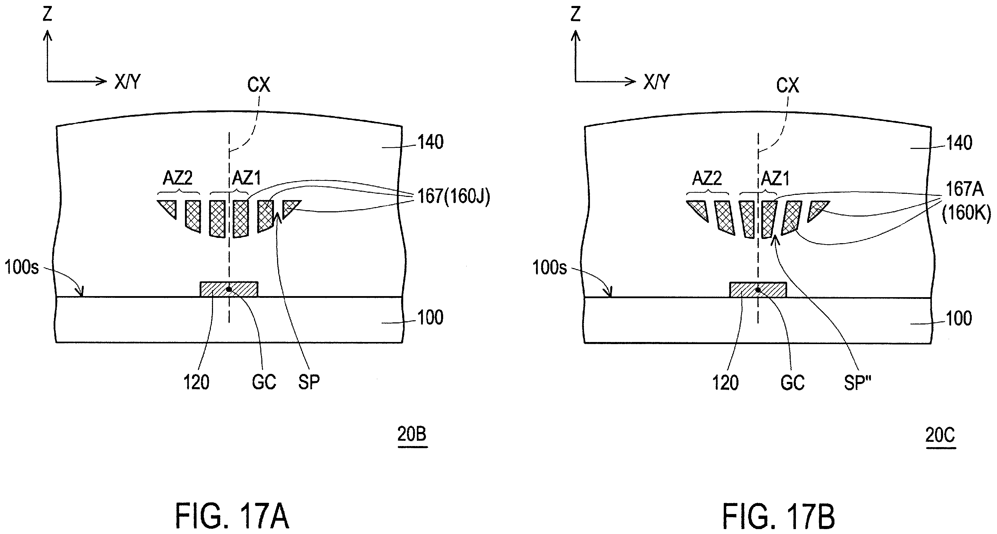

FIG. 17A is a schematic cross-sectional view of a light source module according to the seventh embodiment of the disclosure. FIG. 17B to FIG. 17D are schematic cross-sectional views of light source modules according to some other variation examples of FIG. 17A.

With reference to FIG. 17A, different from the optical pattern 160I shown in FIG. 15, an optical pattern 160J of a light source module 20B of this embodiment may be formed by a plurality of portions 167 separated from each other. For instance, in this embodiment, the portions 167 may be arranged at intervals in the direction X and/or the direction Y, and the intervals between the portions 167 may be the same or different.

It is particularly noted that in this embodiment, the extending direction of a space SP between any two adjacent portions 167 may optionally be perpendicular to the surface 100s of the substrate 100, but not limited thereto. In another variation example, the extending direction of a space SP" between any two adjacent ones among a plurality of portions 167A of an optical pattern 160K of a light source module 20C may substantially pass through the light emitting device 120, as shown in FIG. 17B.

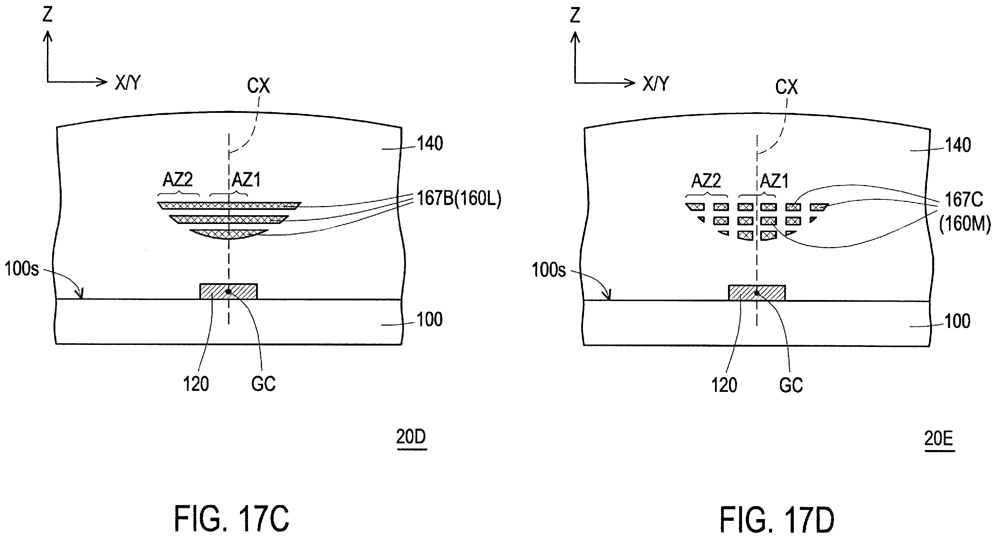

With reference to FIG. 17C, in another variation example, in an optical pattern 160L of a light source module 20D, a plurality of portions 167B may be arranged at intervals in the normal direction (e.g., the direction Z) of the surface 100s of the substrate 100, and the intervals between these portions 167B may be the same or different. With reference to FIG. 17D, in still another variation example, in an optical pattern 160M of a light source module 20E, a plurality of portions 167C may be arranged at intervals in the direction X, in the direction Y, and in the direction Z, and the interval distances of these portions 167C in the same direction or in different directions may be the same or different.

In any optical pattern from FIG. 17A to FIG. 17D, in the optical pattern, the distribution density of these portions in different active zones may be adjusted through the arrangement of the portions separated from each other. As such, the distribution of transmittances (or reflectances) in different active zones in the optical pattern is adjusted to meet the different needs of light output of the light pattern of the light source module.

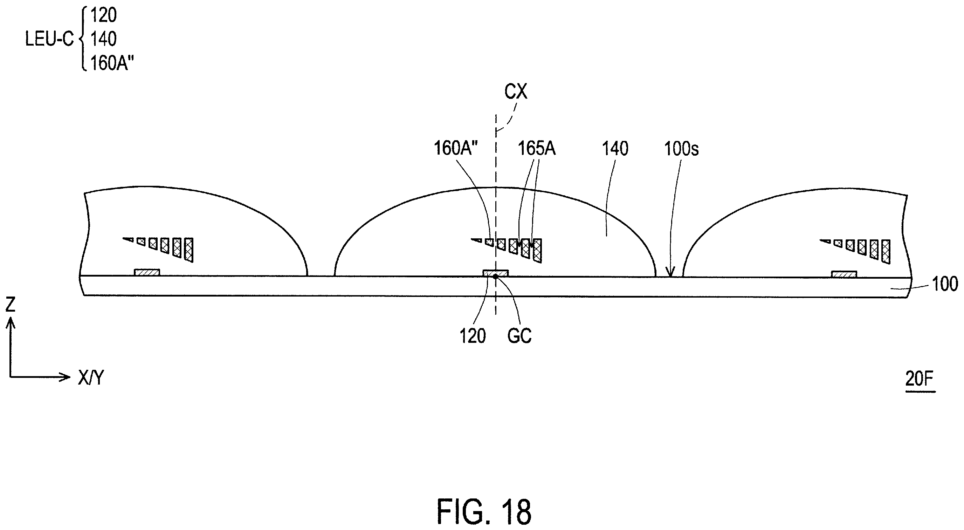

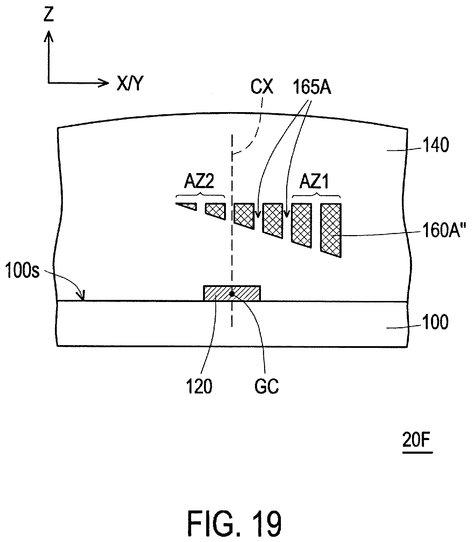

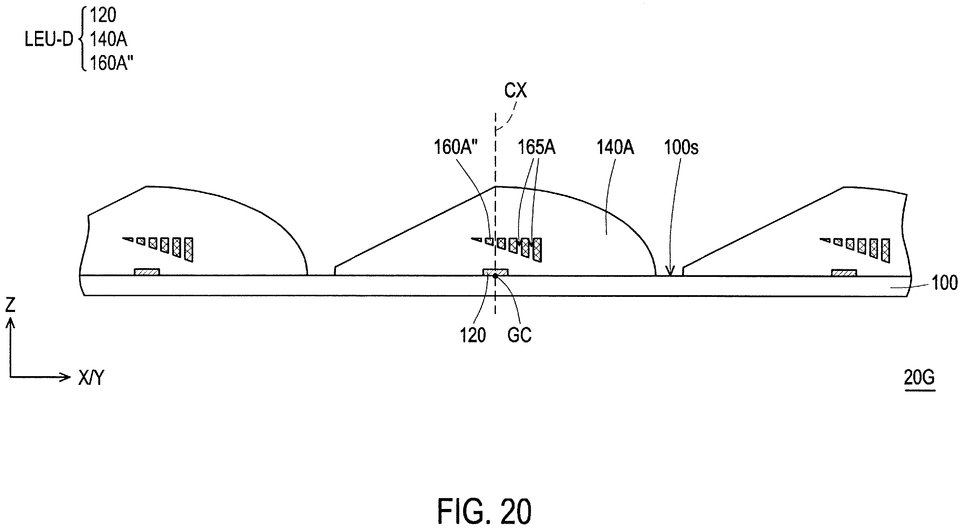

FIG. 18 is a schematic cross-sectional view of a light source module according to the eighth embodiment of the disclosure. FIG. 19 is a schematic local enlargement view of the light source module of FIG. 18. FIG. 20 is a schematic cross-sectional view of a light source module according to the ninth embodiment of the disclosure.

With reference to FIG. 18 and FIG. 19, the difference between a light source module 20F of this embodiment and the light source module 10B of FIG. 4 is that: the configurations and arrangements of the optical patterns are different. Compared to the optical pattern 160A of FIG. 4, an optical pattern 160A" of this embodiment is arranged further away from the central axis CX passing through the geometric center GC of the light emitting device 120 in the direction X or the direction Y, and the optical pattern 160A" is further provided with a plurality of holes 165A. The arrangement pitches of the holes 165A in the direction X and/or the direction Y may be the same or different.

In this embodiment, the encapsulation structure 140 of a light emitting unit LEU-C may be arranged symmetrically about the central axis CX, but not limited thereto. In another embodiment, an encapsulation structure 140A of a light emitting unit LEU-D of a light source module 20G may also be arranged asymmetrically about the central axis CX, as shown in FIG. 20.

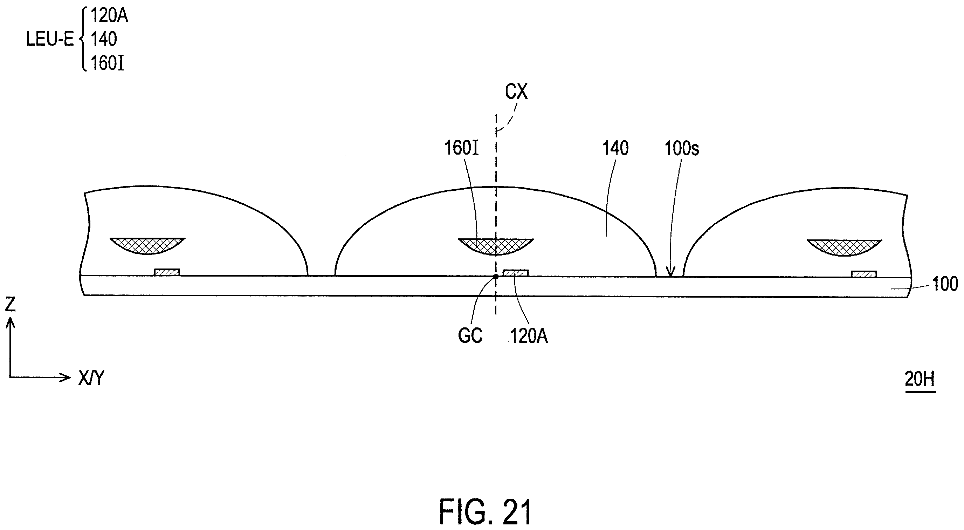

FIG. 21 is a schematic cross-sectional view of a light source module according to the tenth embodiment of the disclosure. With reference to FIG. 21, the difference between a light source module 20H of this embodiment and the light source module 20 of FIG. 14 is that: the arrangements of the light emitting devices are different. In this embodiment, the encapsulation structure 140 and the optical pattern 1601 of a light emitting unit LEU-E are arranged symmetrically about the central axis CX, and the light emitting device 120A is arranged away from the central axis CX. More specifically, the central axis CX does not pass through the light emitting device 120A. Accordingly, the needs of light output of an asymmetric light pattern of the light source module 20H may be satisfied.

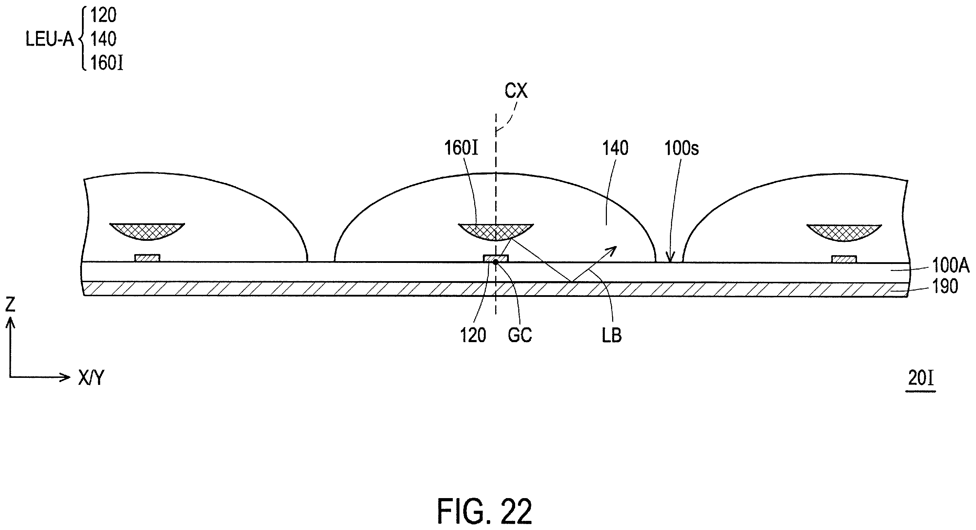

FIG. 22 is a schematic cross-sectional view of a light source module according to the eleventh embodiment of the disclosure. With reference to FIG. 22, in this embodiment, a substrate 100A of a light source module 20I is, for example, a glass substrate, and the at least one light beam LB emitted by the light emitting device 120 is adapted to be transmitted in the glass substrate (i.e., the substrate 100A). That is, the light guiding space of the light emitting unit LEU-A may be increased, so that the uniformity of the light outputted by the light source module 201 is further improved. Further, in order to improve the utilization efficiency of light energy, one side of the substrate 100A away from the light emitting device 120 may further be provided with a reflective sheet 190. Herein, the reflective sheet 190 is, for example, a white reflective sheet or a silver reflective sheet, but not limited thereto.

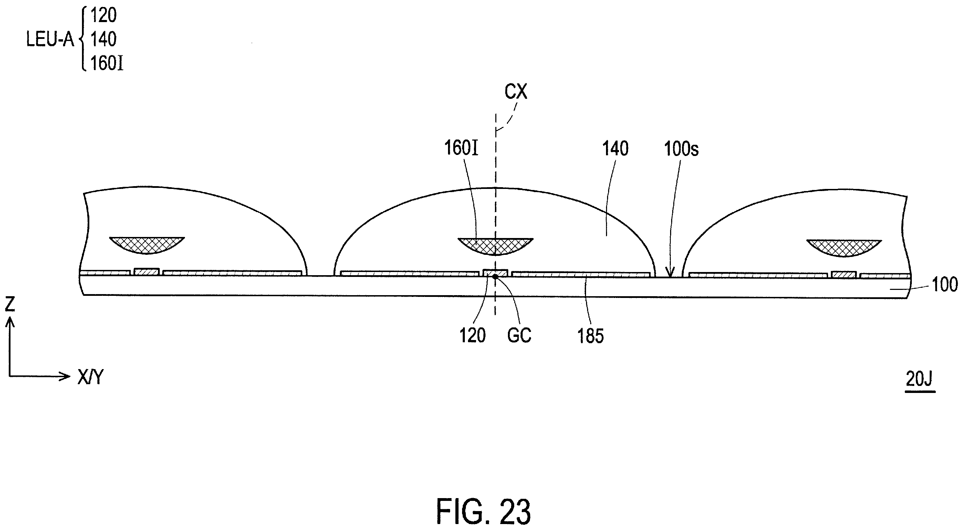

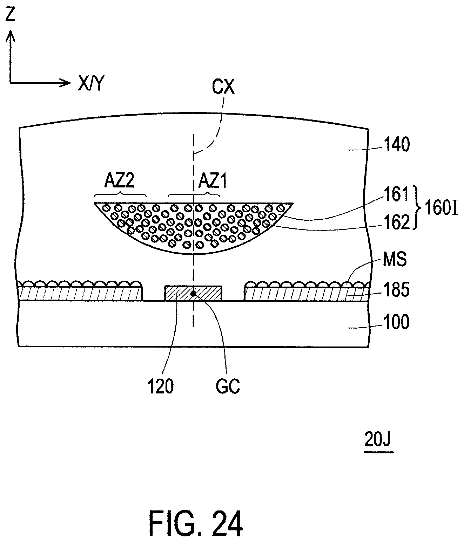

FIG. 23 is a schematic cross-sectional view of a light source module according to the twelfth embodiment of the disclosure. FIG. 5B is a schematic cross-sectional view of the light source module of FIG. 24. With reference to FIG. 23 and FIG. 24, the difference between a light source module 20J of this embodiment and the light source module 20 of FIG. 14 is that: the light source module 20J further includes a reflective layer 185 disposed on the surface 100s of the substrate 100 and exposing the light emitting device 120. In this embodiment, each light emitting unit LEU-A may be provided with one corresponding reflective layer 185 covered by the encapsulation structure 140.

On the other hand, in this embodiment, a side surface of the reflective layer 185 facing the optical pattern 1601 may further be provided with a plurality of surface microstructures MS. When the light reflects off the reflective layer 185, the arrangement of these surface microstructures MS may further improve the light uniformity of the light source module 20J.

It should be particularly noted that when the substrate 100 is a printed circuit board, in order to increase the insulating effect and enhance the reflectivity, in the related art, a solder resist ink layer is formed on the surface 100s of the substrate 100. However, the film thickness of the solder resist ink layer varies greatly between batches often due to the difficulty in process control, and its reflectance may be easily changed by temperature. Therefore, in this embodiment, when the reflective layer 185 provided with the surface microstructures MS is used to replace the commonly-used solder resist ink layer at present, a relatively stable reflection effect can be provided, and the production costs of the light source module 20J may be reduced.

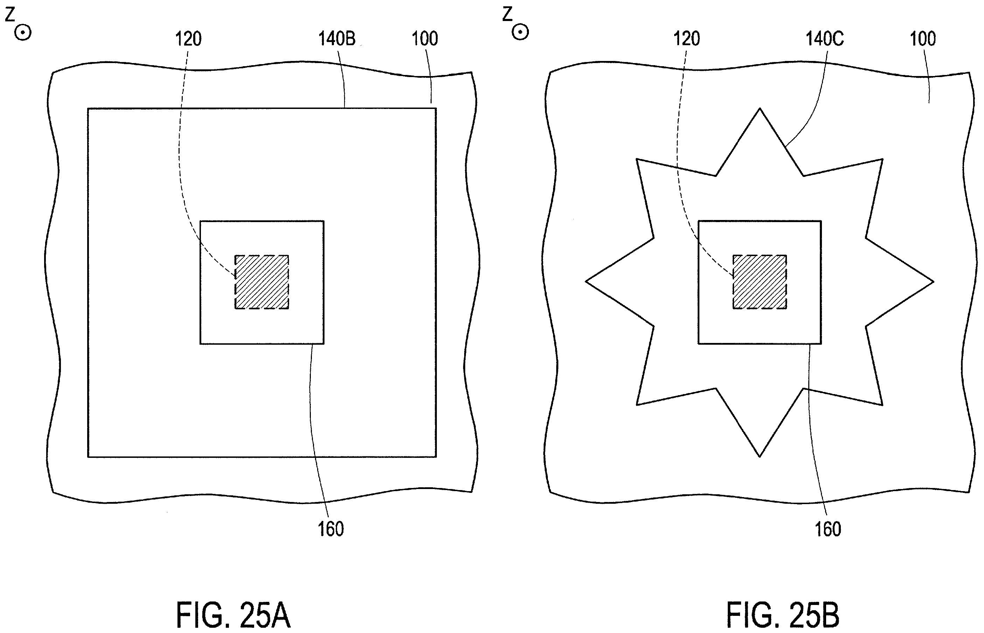

FIG. 25A and FIG. 25B are schematic top views of light emitting units according to some other variation examples of FIG. 2B. Different from the encapsulation structure 140 shown in FIG. 2B, in another variation example, the orthographic projection contour of an encapsulation structure140B on the substrate 100 is, for example, a square or a rectangle, as shown in FIG. 25A. In still another variation example, the orthographic projection contour of an encapsulation structure 140C on the substrate 100 is, for example, a polygon. Through the arrangement of these different contours, the needs of light output of different light patterns of the light emitting unit may thus be satisfied.

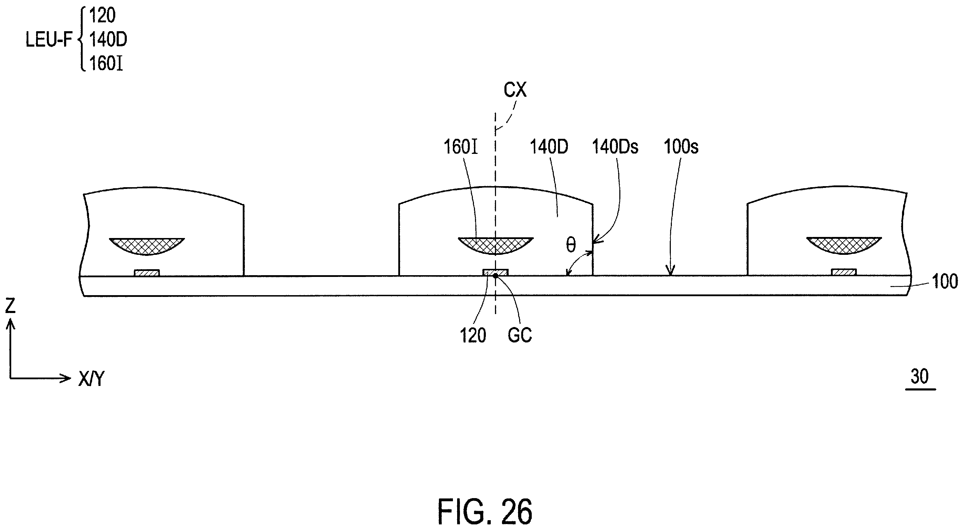

FIG. 26 is a schematic cross-sectional view of a light source module according to the thirteenth embodiment of the disclosure. With reference to FIG. 26, the difference between a light source module 30 of this embodiment and the light source module 20 of FIG. 14 is that: the configurations of the encapsulation structures are different.

In order to solve the problem of increasing production costs and process difficulty of the encapsulation structure due to the increase in the spacing distance of the light emitting devices, different from the encapsulation structure 140 shown in FIG. 14, an encapsulation structure 140D of this embodiment has at least one side surface 140Ds in a direction parallel to the surface 100s of the substrate 100. Further, an included angle θ between the side surface 140Ds and the surface 100s of the substrate 100 may be preferably in a range of 10 degrees to 135 degrees.

In this embodiment, the contour of the side surface 140Ds of the encapsulation structure 140D on a cross section parallel to the XZ plane or the YZ plane is, for example, a straight line. Further, the side surface 140Ds is substantially perpendicular to the surface 100s of the substrate 100 (i.e., the included angle θ is 90 degrees), but not limited thereto.

From another point of view, the side surface 140Ds of the encapsulation structure 140D may be treated as an effective refraction surface when the light is emitted from a light emitting unit LEU-F. In this way, the width of the encapsulation structure 140D in the direction X and the direction Y may be reduced, and the loss of light energy caused by too many reflections of light in the encapsulation structure may also be prevented from occurring.

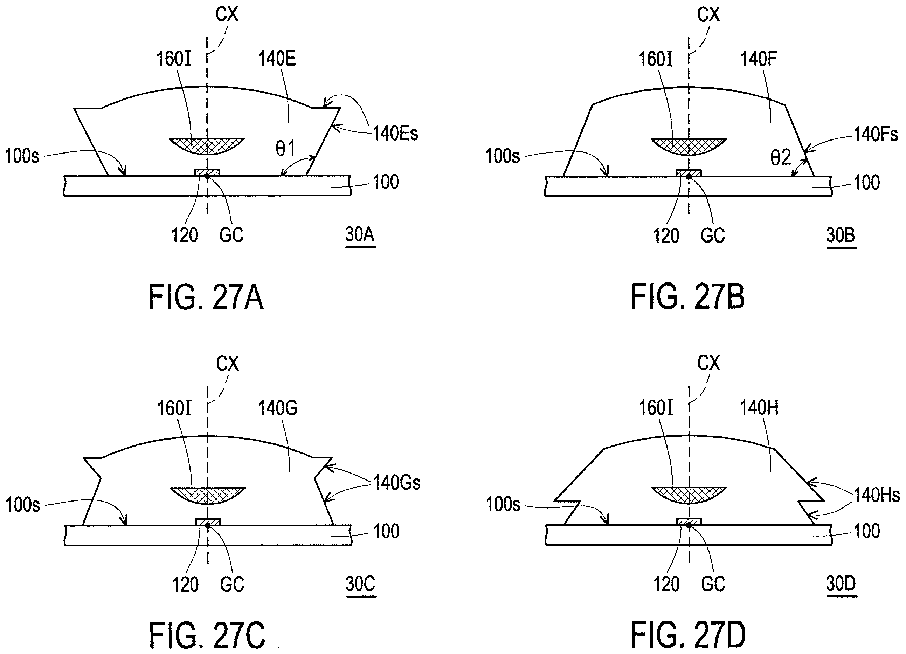

FIG. 27A to FIG. 27D are schematic cross-sectional views of light source modules according to some other variation examples of FIG. 26. In a light source module 30A of a variation example, the contour of a side surface 140Es of an encapsulation structure 140E on a cross section parallel to the XZ plane or the YZ plane is, for example, a broken line formed by bending two connected straight line segments. Further, an included angle θ1 between a portion of the side surface 140Es connected to the substrate 100 and the surface 100s of the substrate 100 is an obtuse angle greater than 90 degrees (as shown in FIG. 27A).

In a light source module 30B in another variation example, the contour of a side surface 140Fs of an encapsulation structure 140F on a cross section parallel to the XZ plane or the YZ plane is, for example, a straight line. Further, an included angle θ2 between the side surface 140Fs and the surface 100s of the substrate 100 is an acute angle less than 90 degrees (as shown in FIG. 27B).

In a light source module 30C in still another variation example, the contour of a side surface 140Gs of an encapsulation structure 140G on a cross section parallel to the XZ plane or the YZ plane is, for example, a broken line. Further, the side surface 140Gs may be formed by bending three connected sub-surfaces (as shown in FIG. 27C). In a light source module 30D in yet another variation example, the contour of a side surface 140Hs of an encapsulation structure 140H on a cross section parallel to the XZ plane or the YZ plane is, for example, a broken line. Further, the side surface 140Hs may be formed by bending three connected sub-surfaces (as shown in FIG. 27D).

In view of the foregoing, in the light source module provided by an embodiment of the disclosure, the light emitting device and optical pattern that overlap each other are covered by the encapsulation structure. The optical pattern is located on the light outputting side of the light emitting device and has the characteristics of partial penetration and partial reflection. Since the optical pattern is embedded in the encapsulation structure, part of the light beam emitted by the light emitting device may be emitted from above the light emitting device through the reflection of the surface of the encapsulation structure and one side surface of the optical pattern away from the light emitting device. Therefore, the problem of the generation of a dark zone caused by the arrangement of the optical pattern above the light emitting device in the light source module may be effectively improved. Further, through the arrangement of different transmittances in different active zones of the optical pattern, the light pattern of the outputted light may be flexibly adjusted.

## Claims

1. A light source module (10, 10A, 10B, 10C, 20, 20A, 20B, 20C, 20D, 20E, 20F, 20G, 20H, 201, 20J, 30, 30A, 30B, 30C, 30D), comprising:
a substrate (100, 100A);
a light emitting device (120, 120A) disposed on a surface (100s) of the substrate (100, 100A);
an encapsulation structure (140, 140A, 140B, 140C, 140D, 140E, 140F, 140G, 140H) disposed on the surface (100s) of the substrate (100, 100A) and covering the light emitting device (120, 120A); and
an optical pattern (160, 160A, 160A', 160A", 160B, 160C, 160D, 160E, 160F, 160G, 160H, 160I, 160J, 160K, 160L, 160M) covered by the encapsulation structure (140, 140A, 140B, 140C, 140D, 140E, 140F, 140G, 140H) and overlapping the light emitting device (120, 120A), wherein the optical pattern (160, 160A, 160A', 160A", 160B, 160C, 160D, 160E, 160F, 160G, 160H, 160I, 160J, 160K, 160L, 160M) has characteristics of partial penetration and partial reflection and is provided with a first active zone (AZ1) and a second active zone (AZ2), the first active zone (AZ1) and the second active zone (AZ2) are arranged in a direction parallel to the surface (100s) of the substrate (100, 100A), the first active zone (AZ1) and the second active zone (AZ2) of the optical pattern (160, 160A, 160A', 160A", 160B, 160C, 160D, 160E, 160F, 160G, 160H, 160I, 160J, 160K, 160L, 160M) respectively has a first transmittance and a second transmittance, the first transmittance is different from the second transmittance, and **characterized in that** the optical pattern (160E) is provided with a plurality of holes (165E1, 165E2, 165E3, 165E4, 165E5, 165F, 165G), a distribution density of the holes (165E1, 165E2, 165E3, 165E4, 165E5, 165F, 165G) in the first active zone (AZ1) is the same as a distribution density of the holes (165E1, 165E2, 165E3, 165E4, 165E5, 165F, 165G) in the second active zone (AZ2), the holes (165E1, 165E2, 165E3, 165E4, 165E5, 165F, 165G) comprise a plurality of first holes (165E1) and a plurality of second holes (165E2), each of the first holes (165E1) has a first hole depth (d1), each of the second holes (165E2) has a second hole depth (d2), and the first hole depth (d1) is different from the second hole depth (d2).

2. The light source module (10, 10A, 10B, 10C, 20, 20A, 20B, 20C, 20D, 20E, 20F, 20G, 20H, 20I, 20J, 30, 30A, 30B, 30C, 30D) according to claim 1, wherein a first height (H1) is provided between a surface of the optical pattern (160, 160A, 160A', 160A", 160B, 160C, 160D, 160E, 160F, 160G, 160H, 160I, 160J, 160K, 160L, 160M) facing the light emitting device (120, 120A) and the surface (100s) of the substrate (100, 100A), the encapsulation structure (140, 140A, 140B, 140C, 140D, 140E, 140F, 140G, 140H) has a second height (H2) in a normal direction of the surface (100s) of the substrate (100, 100A), and a ratio of the first height (H1) to the second height (H2) is less than 0.5.

3. The light source module (10) according to claim 1, wherein the optical pattern (160) has a first surface (160s1) and a second surface (160s2) facing away from each other, the first surface (160s1) faces the light emitting device (120) and is parallel to the second surface (160s2), the optical pattern (160) is provided with a plurality of reflective particles (162) in the first active zone (AZ1) and the second active zone (AZ2), and a doping concentration of the reflective particles (162) in the first active zone (AZ1) is different from a doping concentration in the reflective particles (162) in the second active zone (AZ2).

4. The light source module (10C, 20F, 20G) according to claim 1, wherein the optical pattern (160F) has a first surface (160Fs1) and a second surface (160Fs2) facing away from each other, the holes (165F) extend between the first surface (160Fs1) and the second surface (160Fs2), and an extending direction of each of the holes (165F) is inclined relative to the first surface (160Fs1) or the second surface (160Fs2).

5. The light source module (10C, 20F, 20G) according to claim 1, wherein the optical pattern (160G) has a first surface (160Gs1) and a second surface (160Gs2) facing away from each other, the first surface (160Gs1) has a first opening (OP1) defining each of the holes (165G), the second surface (160Gs2) has a second opening (OP2) defining each of the holes (165G), and an opening area of the first opening (OP1) is different from an opening area of the second opening (OP2).

6. The light source module (10, 10A, 10C, 20, 20A, 20B, 20C, 20D, 20E, 20H, 20I, 20J, 30, 30A, 30B, 30C, 30D) according to claim 1, wherein the light emitting device (120, 120A) has a geometric center (GC), the optical pattern (160, 160A', 160B, 160C, 160D, 160E, 160F, 160G, 160H, 1601, 160J, 160K, 160L, 160M) is arranged symmetrically about a central axis (CX), and the central axis (CX) is perpendicular to the surface (100s) of the substrate (100, 100A) and passes through the geometric center (GC) of the light emitting device (120, 120A).

7. The light source module (20A) according to claim 6, wherein the encapsulation structure (140A) is arranged asymmetrically about the central axis (CX).

8. The light source module (10B, 20F) according to claim 1, wherein the light emitting device (120) has a geometric center (GC), the encapsulation structure (140) is arranged symmetrically about a central axis (CX), and the optical pattern (160A") is arranged asymmetrically about the central axis (CX).

9. The light source module (20G) according to claim 1, wherein the light emitting device (120) has a geometric center (GC), the encapsulation structure (140A) is arranged asymmetrically about a central axis (CX), the central axis (CX) is perpendicular to the surface (100s) of the substrate (100) and passes through the geometric center (GC) of the light emitting device (120), and the optical pattern (160A") is arranged asymmetrically about the central axis (CX).

10. The light source module (20H) according to claim 1, wherein the encapsulation structure (140) is arranged symmetrically about a central axis (CX), the optical pattern (160I) is arranged symmetrically about the central axis (CX), and the central axis (CX) is perpendicular to the surface (100s) of the substrate (100) and does not pass through the light emitting device (120A).

11. The light source module (20I) according to claim 1, wherein the substrate (100A) is a glass substrate, and at least one light beam (LB) emitted by the light emitting device (120) is adapted to be transmitted in the glass substrate (100A).

12. The light source module (20I) according to claim 11, further comprising:
a reflective sheet (190) disposed on a side of the glass substrate (100A) away from the light emitting device (120).

13. The light source module (20J) according to claim 1, further comprising:
a reflective layer (185) disposed on the substrate (100) and exposing the light emitting device (120), wherein the encapsulation structure (140) further comprises the reflective layer (185).

14. The light source module (20J) according to claim 13, wherein the reflective layer (185) has a plurality of surface microstructures (MS).

15. The light source module (30, 30A, 30B, 30C, 30D) according to claim 1, wherein the encapsulation structure (140D, 140E, 140F, 140G, 140H) has at least one side surface in a direction parallel to the surface (100s) of the substrate (100), and an included angle (θ, θ1, θ2) between the at least one side surface (140Ds, 140Es, 140Fs, 140Gs, 140Hs) and the surface (100s) of the substrate (100) is in a range of 10 degrees to 135 degrees.

16. The light source module (30, 30A, 30B, 30C, 30D) according to claim 15, wherein a cross-sectional contour of the at least one side surface (140Ds, 140Es, 140Fs, 140Gs, 140Hs) is a straight line or a broken line.

17. The light source module (20B, 20C, 20D, 20E) according to claim 1, wherein the optical pattern (160J, 160K, 160L, 160M) is a plurality of portions (167, 167A, 167B, 167C) separated from each other, the portions (167, 167A, 167B, 167C) are arranged at intervals in an arrangement direction, the arrangement direction is perpendicular to or parallel to the surface (100s) of the substrate (100), and a distribution density of the portions (167, 167A, 167B, 167C) in the first active zone (AZ1) is different from a distribution density of the portions (167, 167A, 167B, 167C) in the second active zone (AZ2).

## Patentansprüche

1. Lichtquellenmodul (10, 10A, 10B, 10C, 20, 20A, 20B, 20C, 20D, 20E, 20F, 20G, 20H, 20I, 20J, 30, 30A, 30B, 30C, 30D), umfassend:
ein Substrat (100, 100A);
eine Licht emittierende Vorrichtung (120, 120A), die auf einer Oberfläche (100s) des Substrats (100, 100A) angeordnet ist;
eine Einkapselungsstruktur (140, 140A, 140B, 140C, 140D, 140E, 140F, 140G, 140H), die auf der Oberfläche (100s) des Substrats (100, 100A) angeordnet ist und die Licht emittierende Vorrichtung (120, 120A) abdeckt; und
ein optisches Muster (160, 160A, 160A', 160A", 160B, 160C, 160D, 160E, 160F, 160G, 160H, 160I, 160J, 160K, 160L, 160M), das von der Einkapselungsstruktur (140, 140A, 140B, 140C, 140D, 140E, 140F, 140G, 140H) abgedeckt ist und die Licht emittierende Vorrichtung (120, 120A) überlappt, wobei das optische Muster (160, 160A, 160A', 160A", 160B, 160C, 160D, 160E, 160F, 160G, 160H, 160I, 160J, 160K, 160L, 160M) Eigenschaften der teilweisen Durchdringung und teilweisen Reflexion aufweist und mit einer ersten aktiven Zone (AZ1) und einer zweiten aktiven Zone (AZ2) bereitgestellt ist, wobei die erste aktive Zone (AZ1) und die zweite aktive Zone (AZ2) in einer Richtung parallel zu der Oberfläche (100s) des Substrats (100, 100A) angeordnet sind, wobei die erste aktive Zone (AZ1) und die zweite aktive Zone (AZ2) des optischen Musters (160, 160A, 160A', 160A", 160B, 160C, 160D, 160E, 160F, 160G, 160H, 160I, 160J, 160K, 160L, 160M) jeweils eine erste Transmittanz und eine zweite Transmittanz aufweist, wobei sich die erste Transmittanz von der zweiten Transmittanz unterscheidet, und **dadurch gekennzeichnet, dass**
das optische Muster (160E) mit einer Vielzahl von Löchern (165E1, 165E2, 165E3, 165E4, 165E5, 165F, 165G) bereitgestellt ist, ine Verteilungsdichte der Löcher (165E1, 165E2, 165E3, 165E4, 165E5, 165F, 165G) in der ersten aktiven Zone (AZ1) gleich einer Verteilungsdichte der Löcher (165E1, 165E2, 165E3, 165E4, 165E5, 165F, 165G) in der zweiten aktiven Zone (AZ2) ist, die Löcher (165El , 165E2, 165E3, 165E4, 165E5, 165F, 165G) eine Vielzahl von ersten Löchern (165E1) und eine Vielzahl von zweiten Löchern (165E2) umfassen, jedes der ersten Löcher (165E1) eine erste Lochtiefe (d1) aufweist, jedes der zweiten Löcher (165E2) eine zweite Lochtiefe (d2) aufweist und die erste Lochtiefe (d1) sich von der zweiten Lochtiefe (d2) unterscheidet.

2. Lichtquellenmodul (10, 10A, 10B, 10C, 20, 20A, 20B, 20C, 20D, 20E, 20F, 20G, 20H, 20I, 20J, 30, 30A, 30B, 30C, 30D) nach Anspruch 1, wobei eine erste Höhe (H1) zwischen einer Oberfläche des optischen Musters (160, 160A, 160A', 160A", 160B, 160C, 160D, 160E, 160F, 160G, 160H, 160I, 160J, 160K, 160L, 160M), die der Licht emittierenden Vorrichtung (120, 120A) zugewandt ist, und der Oberfläche (100s) des Substrats (100, 100A) bereitgestellt ist, die Einkapselungsstruktur (140, 140A, 140B, 140C, 140D, 140E, 140F, 140D, 140H) eine zweite Höhe (H2) in einer Normalenrichtung der Oberfläche (100s) des Substrats (100, 100A) aufweist, und ein Verhältnis der ersten Höhe (H1) zu der zweiten Höhe (H2) kleiner als 0,5 ist.

3. Lichtquellenmodul (10) nach Anspruch 1, wobei das optische Muster (160) eine erste Oberfläche (160s1) und eine zweite Oberfläche (160s2) aufweist, die einander abgewandt sind, wobei die erste Oberfläche (160s1) der Licht emittierenden Vorrichtung (120) zugewandt ist und parallel zu der zweiten Oberfläche (160s2) verläuft, das optische Muster (160) mit einer Vielzahl von reflektierenden Partikeln (162) in der ersten aktiven Zone (AZ1) und der zweiten aktiven Zone (AZ2) bereitgestellt ist und sich eine Dotierungskonzentration der reflektierenden Partikel (162) in der ersten aktiven Zone (AZ1) von einer Dotierungskonzentration der reflektierenden Partikel (162) in der zweiten aktiven Zone (AZ2) unterscheidet.

4. Lichtquellenmodul (10C, 20F, 20G) nach Anspruch 1, wobei das optische Muster (160F) eine erste Oberfläche (160Fs1) und eine zweite Oberfläche (160Fs2) aufweist, die einander abgewandt sind, sich die Löcher (165F) zwischen der ersten Oberfläche (160Fs1) und der zweiten Oberfläche (160Fs2) erstrecken und eine Erstreckungsrichtung jedes der Löcher (165F) relativ zu der ersten Oberfläche (160Fs1) oder zu der zweiten Oberfläche (160Fs2) geneigt ist.

5. Lichtquellenmodul (10C, 20F, 20G) nach Anspruch 1, wobei das optische Muster (160G) eine erste Oberfläche (160Gs1) und eine zweite Oberfläche (160Gs2) aufweist, die einander abgewandt sind, wobei die erste Oberfläche (1600s1) eine erste Öffnung (OP1) aufweist, die jedes der Löcher (165G) definiert, die zweite Oberfläche (160Gs2) eine zweite Öffnung (OP2) aufweist, die jedes der Löcher (165G) definiert, und sich eine Öffnungsfläche der ersten Öffnung (OP1) von einer Öffnungsfläche der zweiten Öffnung (OP2) unterscheidet.

6. Lichtquellenmodul (10, 10A, 10C, 20, 20A, 20B, 20C, 20D, 20E, 20H, 20I, 20J, 30, 30A, 30B, 30C, 30D) nach Anspruch 1, wobei die Licht emittierende Vorrichtung (120, 120A) einen geometrischen Mittelpunkt (GC) aufweist, das optische Muster (160, 160A', 160B, 160C, 160D, 160E, 160F, 160G, 160H, 160I, 160J, 160K, 160L, 160M) symmetrisch um eine Mittelachse (CX) angeordnet ist und die Mittelachse (CX) senkrecht zu der Oberfläche (100s) des Substrats (100, 100A) steht und durch den geometrischen Mittelpunkt (GC) der Licht emittierenden Vorrichtung (120, 120A) verläuft.

7. Lichtquellenmodul (20A) nach Anspruch 6, wobei die Einkapselungsstruktur (140A) asymmetrisch um die Mittelachse (CX) angeordnet ist.

8. Lichtquellenmodul (10B, 20F) nach Anspruch 1, wobei die Licht emittierende Vorrichtung (120) einen geometrischen Mittelpunkt (GC) aufweist, die Einkapselungsstruktur (140) symmetrisch um eine Mittelachse (CX) angeordnet ist und das optische Muster (160A") asymmetrisch um die Mittelachse (CX) angeordnet ist.

9. Lichtquellenmodul (20G) nach Anspruch 1, wobei die Licht emittierende Vorrichtung (120) einen geometrischen Mittelpunkt (GC) aufweist, die Einkapselungsstruktur (140A) asymmetrisch um eine Mittelachse (CX) angeordnet ist, die Mittelachse (CX) senkrecht zu der Oberfläche (100s) des Substrats (100) steht und durch den geometrischen Mittelpunkt (GC) der Licht emittierenden Vorrichtung (120) verläuft, und das optische Muster (160A") asymmetrisch um die Mittelachse (CX) angeordnet ist.

10. Lichtquellenmodul (20H) nach Anspruch 1, wobei die Einkapselungsstruktur (140) symmetrisch um eine Mittelachse (CX) angeordnet ist, das optische Muster (160I) symmetrisch um die Mittelachse (CX) angeordnet ist und die Mittelachse (CX) senkrecht zu der Oberfläche (100s) des Substrats (100) steht und nicht durch die Licht emittierende Vorrichtung (120A) verläuft.

11. Lichtquellenmodul (20I) nach Anspruch 1, wobei das Substrat (100A) ein Glassubstrat ist und mindestens ein von der Licht emittierenden Vorrichtung (120) emittierter Lichtstrahl (LB) so angepasst ist, dass er in dem Glassubstrat (100A) übertragen wird.

12. Lichtquellenmodul (201) nach Anspruch 11, ferner umfassend:
eine reflektierende Folie (190), die auf einer Seite des Glassubstrats (100A) angeordnet ist, die von der Licht emittierenden Vorrichtung (120) entfernt ist.

13. Lichtquellenmodul (20J) nach Anspruch 1, ferner umfassend:
eine reflektierende Schicht (185), die auf dem Substrat (100) angeordnet ist und die Licht emittierende Vorrichtung (120) freilegt, wobei die Einkapselungsstruktur (140) ferner die reflektierende Schicht (185) umfasst.

14. Lichtquellenmodul (20J) nach Anspruch 13, wobei die reflektierende Schicht (185) eine Vielzahl von Oberflächenmikrostrukturen (MS) aufweist.

15. Lichtquellenmodul (30, 30A, 30B, 30C, 30D) nach Anspruch 1, wobei die Einkapselungsstruktur (140D, 140E, 140F, 140D, 140H) mindestens eine Seitenfläche in einer Richtung parallel zu der Oberfläche (100s) des Substrats (100) aufweist und ein eingeschlossener Winkel (θ, θ1, θ2) zwischen der mindestens einen Seitenfläche (140Ds, 140Es, 140Fs, 140Gs, 140Hs) und der Oberfläche (100s) des Substrats (100) in einem Bereich von 10 Grad bis 135 Grad liegt.

16. Lichtquellenmodul (30, 30A, 30B, 30C, 30D) nach Anspruch 15, wobei eine Querschnittskontur der mindestens einen Seitenfläche (140Ds, 140Es, 140Fs, 140Gs, 140Hs) eine gerade Linie oder eine gebrochene Linie ist.

17. Lichtquellenmodul (20B, 20C, 20D, 20E) nach Anspruch 1, wobei das optische Muster (160J, 160K, 160L, 160M) eine Vielzahl von Abschnitten (167, 167A, 167B, 167C) ist, die voneinander getrennt sind, die Abschnitte (167, 167A, 167B, 167C) in Abständen in einer Anordnungsrichtung angeordnet sind, die Anordnungsrichtung senkrecht oder parallel zu der Oberfläche (100s) des Substrats (100) ist und sich eine Verteilungsdichte der Abschnitte (167, 167A, 167B, 167C) in der ersten aktiven Zone (AZ1) von einer Verteilungsdichte der Abschnitte (167, 167A, 167B, 167C) in der zweiten aktiven Zone (AZ2) unterscheidet.

## Revendications

1. Module de source lumineuse (10, 10A, 10B, 10C, 20, 20A, 20B, 20C, 20D, 20E, 20F,
20G, 20H, 20I, 20J, 30, 30A, 30B, 30C, 30D), comprenant:
un substrat (100, 100A);
un dispositif électroluminescent (120, 120A) disposé sur une surface (100s) du substrat (100, 100A);
une structure d'encapsulation (140, 140A, 140B, 140C, 140D, 140E, 140F, 140G, 140H) disposée sur la surface (100s) du substrat (100, 100A) et recouvrant le dispositif émetteur de lumière (120, 120A); et
un motif optique (160, 160A, 160A', 160A", 160B, 160C, 160D, 160E, 160F, 160G, 160H, 160I, 160J, 160K, 160L, 160M) recouvert par la structure d'encapsulation (140, 140A, 140B, 140C, 140D, 140E, 140F, 140G, 140H) et recouvrant le dispositif émetteur de lumière (120, 120A), dans lequel le motif optique (160, 160A, 160A', 160A", 160B, 160C, 160D, 160E, 160F, 160G, 160H, 160I, 160J, 160K, 160L, 160M) présente des caractéristiques de pénétration partielle et de réflexion partielle et est pourvu d'une première zone active (AZ1) et d'une deuxième zone active (AZ2), la première zone active (AZ1) et la deuxième zone active (AZ2) sont disposées dans une direction parallèle à la surface (100s) du substrat (100, 100A), la première zone active (AZ1) et la deuxième zone active (AZ2) du motif optique (160, 160A, 160A', 160A", 160B, 160C, 160D, 160E, 160F, 160G, 160H, 160I, 160J, 160K, 160L, 160M) ont respectivement une première transmittance et une deuxième transmittance, la première transmittance étant différente de la deuxième transmittance, **caractérisé en ce que** le motif optique (160E) est pourvu
d'une pluralité de trous (165E1, 165E2, 165E3, 165E4, 165E5, 165F, 165G), une densité de distribution des trous (165E1, 165E2, 165E3, 165E4, 165E5, 165F, 165G) dans la première zone active (AZ1) est la même qu'une densité de distribution des trous (165E1, 165E2, 165E3, 165E4, 165E5, 165F, 165G) dans la deuxième zone active (AZ2), les trous (165E1, 165E2, 165E3, 165E4, 165E5, 165F, 165G) comprennent une pluralité de premiers trous (165E1) et une pluralité de seconds trous (165E2), chacun des premiers trous (165E1) a une première profondeur de trou (d1), chacun des seconds trous (165E2) a une seconde profondeur de trou (d2), et la première profondeur de trou (d1) est différente de la seconde profondeur de trou (d2).

2. Le module de source lumineuse (10, 10A, 10B, 10C, 20, 20A, 20B, 20C, 20D, 20E, 20F, 20G, 20H, 20I, 20J, 30, 30A, 30B, 30C, 30D) selon la revendication 1, dans lequel une première hauteur (H1) est prévue entre une surface du motif optique (160, 160A, 160A', 160A", 160B, 160C, 160D, 160E, 160F, 160G, 160H, 160I, 160J, 160K, 160L, 160M) faisant face au dispositif d'émission de lumière (120, 120A) et la surface (100s) du substrat (100, 100A), la structure d'encapsulation (140, 140A, 140B, 140C, 140D, 140E, 140F, 140G, 140H) a une deuxième hauteur (H2) dans une direction normale à la surface (100s) du substrat (100, 100A), et un rapport entre la première hauteur (H1) et la deuxième hauteur (H2) est inférieur à 0,5.

3. Module de source lumineuse (10) selon la revendication 1, dans lequel le motif optique (160) présente une première surface (160s1) et une deuxième surface (160s2) opposées l'une à l'autre, la première surface (160s1) fait face au dispositif d'émission de lumière (120) et est parallèle à la deuxième surface (160s2), le motif optique (160) est pourvu d'une pluralité de particules réfléchissantes (162) dans la première zone active (AZ1) et la deuxième zone active (AZ2), et une concentration de dopage des particules réfléchissantes (162) dans la première zone active (AZ1) est différente d'une concentration de dopage dans les particules réfléchissantes (162) dans la deuxième zone active (AZ2).

4. Module de source lumineuse (10C, 20F, 20G) selon la revendication 1, dans lequel le motif optique (160F) comporte une première surface (160Fs1) et une deuxième surface (160Fs2) opposées l'une à l'autre, les trous (165F) s'étendent entre la première surface (160Fs1) et la deuxième surface (160Fs2), et la direction d'extension de chacun des trous (165F) est inclinée par rapport à la première surface (160Fs1) ou à la deuxième surface (160Fs2).

5. Module de source lumineuse (10C, 20F, 20G) selon la revendication 1, dans lequel le motif optique (1600) comporte une première surface (160Gs1) et une deuxième surface (1600s2) opposées l'une à l'autre, la première surface (1600s1) comporte une première ouverture (OP1) définissant chacun des trous (165G), la deuxième surface (160Gs2) comporte une deuxième ouverture (OP2) définissant chacun des trous (165G), et une surface d'ouverture de la première ouverture (OP1) est différente d'une surface d'ouverture de la deuxième ouverture (OP2).

6. Module de source lumineuse (10, 10A, 10C, 20, 20A, 20B, 20C, 20D, 20E, 20H, 20I, 20J, 30, 30A, 30B, 30C, 30D) selon la revendication 1, dans lequel le dispositif d'émission de lumière (120, 120A) a un centre géométrique (GC), le motif optique (160, 160A', 160B, 160C, 160D, 160E, 160F, 160G, 160H, 160I, 160J, 160K, 160L, 160M) est disposé symétriquement autour d'un axe central (CX), et l'axe central (CX) est perpendiculaire à la surface (100s) du substrat (100, 100A) et passe par le centre géométrique (GC) du dispositif émetteur de lumière (120, 120A).

7. Module de source lumineuse (20A) selon la revendication 6, dans lequel la structure d'encapsulation (140A) est disposée de manière asymétrique autour de l'axe central (CX).

8. Module de source lumineuse (10B, 20F) selon la revendication 1, dans lequel le dispositif émetteur de lumière (120) a un centre géométrique (GC), la structure d'encapsulation (140) est disposée symétriquement autour d'un axe central (CX) et le motif optique (160A") est disposé asymétriquement autour de l'axe central (CX).

9. Module de source lumineuse (20G) selon la revendication 1, dans lequel le dispositif émetteur de lumière (120) a un centre géométrique (GC), la structure d'encapsulation (140A) est disposée de manière asymétrique autour d'un axe central (CX), l'axe central (CX) est perpendiculaire à la surface (100s) du substrat (100) et passe par le centre géométrique (GC) du dispositif émetteur de lumière (120), et le motif optique (160A") est disposé de manière asymétrique autour de l'axe central (CX).

10. Module de source lumineuse (20H) selon la revendication 1, dans lequel la structure d'encapsulation (140) est disposée symétriquement autour d'un axe central (CX), le motif optique (160I) est disposé symétriquement autour de l'axe central (CX), et l'axe central (CX) est perpendiculaire à la surface (100s) du substrat (100) et ne passe pas à travers le dispositif électroluminescent (120A).

11. Module de source lumineuse (20I) selon la revendication 1, dans lequel le substrat (100A) est un substrat en verre, et au moins un faisceau lumineux (LB) émis par le dispositif émetteur de lumière (120) est adapté à être transmis dans le substrat en verre (100A).

12. Module de source lumineuse (20I) selon la revendication 11, comprenant en outre :une feuille réfléchissante (190) disposée sur un côté du substrat en verre (100A) éloigné du dispositif émetteur de lumière (120).

13. Module de source lumineuse (20J) selon la revendication 1, comprenant en outre :une couche réfléchissante (185) disposée sur le substrat (100) et exposant le dispositif électroluminescent (120), dans lequel la structure d'encapsulation (140) comprend en outre la couche réfléchissante (185).

14. Module de source lumineuse (20J) selon la revendication 13, dans lequel la couche réfléchissante (185) comporte une pluralité de microstructures de surface (MS).

15. Module de source lumineuse (30, 30A, 30B, 30C, 30D) selon la revendication 1, dans lequel la structure d'encapsulation (140D, 140E, 140F, 140G, 140H) comporte au moins une surface latérale dans une direction parallèle à la surface (100s) du substrat (100), et un angle inclus (θ, θ1, θ2) entre au moins une surface latérale (140Ds, 140Es, 140Fs, 140Gs, 140Hs) et la surface (100s) du substrat (100) est compris entre 10 degrés et 135 degrés.

16. Module de source lumineuse (30, 30A, 30B, 30C, 30D) selon la revendication 15, dans lequel un contour en coupe transversale de au moins une surface latérale (140Ds, 140Es, 140Fs, 140Gs, 140Hs) est une ligne droite ou une ligne brisée.

17. Module de source lumineuse (20B, 20C, 20D, 20E) selon la revendication 1, dans lequel le motif optique (160J, 160K, 160L, 160M) est constitué d'une pluralité de parties (167, 167A, 167B, 167C) séparées les unes des autres, les parties (167, 167A, 167B, 167C) sont disposées à intervalles dans une direction d'agencement, la direction d'agencement est perpendiculaire ou parallèle à la surface (100s) du substrat (100), et une densité de distribution des parties (167, 167A, 167B, 167C) dans la première zone active (AZ1) est différente d'une densité de distribution des parties (167, 167A, 167B, 167C) dans la deuxième zone active (AZ2).
